# EUROPEAN PATENT SPECIFICATION

(11) **EP 3 958 318 B1**
(45) Date of publication and mention of the grant of the patent: **20.08.2025**
(21) Application number: 20790815.3
(22) Date of filing: 17.01.2020
(51) Int. Cl.: H10H 29/32

(54) **DISPLAY DEVICE AND METHOD FOR MANUFACTURING SAME**
ANZEIGEVORRICHTUNG UND VERFAHREN ZUR HERSTELLUNG DAVON
DISPOSITIF D'AFFICHAGE ET SON PROCÉDÉ DE FABRICATION

(30) Priority: 15.04.2019 KR 20190043919
(43) Date of publication of application: 23.02.2022
(73) Proprietor: Samsung Display Co., Ltd., Yongin-si, Gyeonggi-Do 17113 (KR)
(72) Inventor: YANG, Eun A, Yongin-si, Gyeonggi-do 17113 (KR); KANG, Jong Hyuk, Yongin-si, Gyeonggi-do 17113 (KR); IM, Hyun Deok, Yongin-si, Gyeonggi-do 17113 (KR); CHO, Hyun Min, Yongin-si, Gyeonggi-do 17113 (KR)
(74) Representative: Marks & Clerk LLP
(86) International application number: PCT/KR2020/000884
(87) International publication number: WO 2020/213822

(56) References cited:
- JP-A- 2013 080 874
- KR-A- 20180 007 376
- KR-A- 20180 072 909
- KR-A- 20190 034 379
- TW-U- M 573 054
- US-A1- 2017 186 740
- US-A1- 2017 338 372
- US-A1- 2018 175 009

## Description

### Technical Field

The present disclosure relates to a display device including a subminiature light emitting element, and a method of fabricating the display device.

### Background Art

A light emitting diode may have relatively satisfactory durability even under poor environmental conditions, and have desirable performances in terms of lifespan and luminance.

To apply the LED to a lighting device, a display device, or the like, there is a need to couple the LED to an electrode so that the voltage of the power supply may be applied to the LED. With regard to application purposes of the LED, a method of reducing space needed for the electrode, or a method of fabricating the LED, various researches on the arrangement relationship between the LED and the electrode have been conducted.
US 2018/175009 A1 relates to a light emitting device and a display device including the same. TW M 573 054 U relates to a drive backplane, a micro LED display panel and a display. US 2017/186740 relates to matrix-addressed device repair. KR 2019 0034379 A relates to a light emitting diode device and a method of manufacturing for the same.

### Disclosure

### Technical Problem

An object of the present disclosure is to provide a display device in which light emitting elements are aligned in various directions in an emission area so that uniform light output distribution may be achieved in an overall area of the display device. Furthermore, an object of the present disclosure is to provide a method of fabricating the display device.

### Technical Solution

A display device in accordance with an embodiment of the present invention includes: a substrate including a display area and a non-display area; and at least one pixel provided in the display area, the at least one including an emission area formed to emit light.

In accordance with the present invention, the pixel includes: first electrodes disposed on the substrate and disposed in a column direction; second electrodes spaced apart from the first electrodes; a first connection line extending in the column direction, and connecting each of the first electrodes to an adjacent first electrode; a light emitting element electrically connected to each of at least one of the first electrodes and at least one of the second electrodes; and an insulating pattern overlapping the first connection line.

In accordance with the present invention, each of the first electrodes and each of the second electrodes are alternately disposed in the column direction in the emission area in a plan view.

In accordance with the present invention, each of the second electrodes includes : a bridge pattern extending in a row direction intersecting the column direction, and overlapping the insulating pattern; and at least two or more sub-electrodes electrically connected to each other by the bridge pattern.

In accordance with an embodiment of the present disclosure, the bridge pattern and the sub-electrodes may be integral with each other and form at least one of the second electrodes.

In accordance with an embodiment of the present disclosure, at least one of the first electrodes may be disposed between two of the second electrodes adjacent thereto in the column direction.

In accordance with an embodiment of the present disclosure, the insulating pattern may be disposed on the bridge pattern.

In accordance with an embodiment of the present disclosure, the first connection line may be disposed on a layer different from that of the first electrodes.

In accordance with an embodiment of the present disclosure, the first connection line may be disposed on the insulating pattern and electrically disconnected from the bridge pattern.

In accordance with an embodiment of the present disclosure, the first connection line may include a first part overlapping the insulating pattern, and a second part other than the first part. The second part of the first connection line may be electrically connected with the first electrodes.

In accordance with an embodiment of the present disclosure, the pixel may further include: a first capping layer disposed on the first electrodes; a second capping layer disposed on the second electrodes; and a third capping layer disposed on the first connection line.

In accordance with an embodiment of the present disclosure, the first and the second capping layers may be disposed on an identical layer, and the third capping layer may be disposed on a layer different from the first and the second capping layers.

In accordance with an embodiment of the present disclosure, the pixel may further include a second connection line electrically connected with the second electrodes. The second connection line may include: a 2-1-th connection line extending in the row direction; and a 2-2-th connection line extending in the column direction. The 2-2-th connection line may be integral with the second electrodes.

In accordance with an embodiment of the present disclosure, the second connection line may be disposed on a layer different from that of the first connection line.

In accordance with an embodiment of the present disclosure, the pixel may further include: a partition wall disposed under each of the first electrodes and the second electrodes; a first contact electrode electrically connecting at least one of the first electrodes with an end of opposite ends of the light emitting element; and a second contact electrode electrically connecting at least one of the second electrodes with another end of the opposite ends of the light emitting element.

In accordance with an embodiment of the present disclosure, the pixel may further include an insulating layer disposed on an upper surface of the light emitting element. The first contact electrode and the second contact electrode may be spaced apart from each other on the insulating layer and be electrically disconnected from each other.

In accordance with an embodiment of the present disclosure, the first electrodes and the first connection line may be integral with each other.

In accordance with an embodiment of the present disclosure, the insulating pattern may be disposed on the first connection line, and the bridge pattern may be disposed on the insulating pattern.

In accordance with an embodiment of the present disclosure, the first electrodes and the second electrodes may be disposed on different layers.

In accordance with an embodiment of the present disclosure, the pixel may include: a first capping layer disposed on each of the first electrodes and the first connection line; and a second capping layer disposed on the second electrodes. The first capping layer and the second capping layer may be disposed on different layers.

A method of fabricating a display device in accordance with the present invention includes: providing a substrate including at least one pixel having an emission area and a non-emission area; and forming, in the emission area of the pixel, a display element layer emitting light.

In accordance with the present invention, forming the display element layer includes:
forming, in the emission area, first electrodes, second electrodes, and a first connection line electrically connected to the second electrodes; forming an insulating pattern overlapping portions of the second electrodes; forming, on the insulating pattern, a second connection line electrically connected with the first electrodes; aligning light emitting elements between at least one of the first electrodes and at least one of the second electrodes; and forming a first contact electrode electrically connecting the at least one first electrodes and an end of opposite ends of the light emitting element, and a second contact electrode electrically connecting the at least one second electrodes and another end of the opposite ends of the light emitting element. Each of the second electrodes (EL2) comprises: a bridge pattern extending in a row direction and overlapping the insulating pattern; and two or more sub-electrodes connected to each other by the bridge pattern.

### Advantageous Effects

An embodiment of the present disclosure may provide a display device in which light emitting elements are aligned in various directions so that uniform light output distribution may be achieved in an overall area, and a method of fabricating the display device.

The effects of the present disclosure are not limited by the foregoing, and other various effects are anticipated herein.

### Description of Drawings

FIG. 1a is a perspective view schematically illustrating a light emitting element in accordance with an embodiment of the present disclosure.
FIG. 1b is a schematic cross-sectional view illustrating the light emitting element of FIG. 1a.
FIG. 1c is a perspective view schematically illustrating a light emitting element in accordance with an embodiment of the present disclosure.
FIG. 1d is a schematic cross-sectional view illustrating the light emitting element of FIG. 1c.
FIG. 1e is a perspective view schematically illustrating a light emitting element in accordance with an embodiment of the present disclosure.
FIG. 1f is a schematic cross-sectional view illustrating the light emitting element of FIG. 1e.
FIG. 2 illustrates a display device in accordance with an embodiment of the present disclosure, and particularly, is a schematic plan view illustrating a display device using any one light emitting element of the light emitting elements illustrated in FIGS. 1a to 1f as a light emitting source.
FIGS. 3a to 3c are schematic circuit diagrams illustrating various embodiments of electrical connection relationship of components included in any of the pixels illustrated in FIG. 2.
FIG. 4 is a plan view schematically illustrating three pixels adjacent to each other in a row direction among the pixels shown in FIG. 2.
FIG. 5 is a plan view schematically illustrating only first and second electrodes and light emitting elements aligned therebetween among first to third pixels of FIG. 4.
FIG. 6 is a schematic cross-sectional view taken along line I-I' of FIG. 4.
FIG. 7 is a schematic cross-sectional view taken along line II-II' of FIG. 4.
FIG. 8 illustrates an embodiment in which the first and second electrodes shown in FIG. 7 are disposed on an identical layer, and is a schematic cross-sectional view corresponding to line II-II' of FIG. 4.
FIG. 9 illustrates another shape of a partition wall (or bank pattern) illustrated in FIG. 7, and is a schematic cross-sectional view corresponding to line II-II' of FIG. 4.
FIG. 10 is a schematic cross-sectional diagram taken along line III-III' of FIG. 4.
FIGS. 11a to 11i are schematic plan views sequentially illustrating a method of fabricating a first pixel illustrated in FIG. 4.
FIGS. 12a to 12n are schematic cross-sectional views sequentially illustrating a method of fabricating the first pixel illustrated in FIG. 6.
FIGS. 13a and 13b illustrate an embodiment of the first pixel of FIG. 5, and are plan views schematically illustrating the first pixel including only some components of a display element layer.
FIG. 14 illustrates a display device in accordance with an embodiment of the present disclosure, and is a schematic plan view corresponding to the first pixel of the first to third pixels of FIG. 4.
FIG. 15 is a schematic cross-sectional diagram taken along line IV-IV' of FIG. 14.
FIG. 16 is a schematic cross-sectional diagram taken along line V-V' of FIG. 14.

### Mode for Invention

As the present disclosure allows for various changes and numerous embodiments, particular embodiments will be illustrated in the drawings and described in detail in the written description. However, this is not intended to limit the present disclosure to particular modes of practice, and it is to be appreciated that all changes, equivalents, and substitutes that do not depart from the technical scope of the present disclosure are encompassed in the present disclosure.

Throughout the disclosure, like reference numerals refer to like parts throughout the various figures and embodiments of the present disclosure. The sizes of elements in the accompanying drawings may be exaggerated for clarity of illustration. It will be understood that, although the terms "first," "second," and the like may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element. In the present disclosure, the singular forms are intended to include the plural forms as well, unless the context clearly indicates otherwise.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, when a first part such as a layer, a film, a region, or a plate is disposed on a second part, the first part may be not only directly on the second part but a third part may intervene between them. In addition, when it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, when a first part such as a layer, a film, a region, or a plate is under a second part, the first part may be not only directly under the second part but a third part may intervene between them.

Embodiments and required details of the present disclosure are described with reference to the accompanying drawings in order to describe the present disclosure in detail so that those having ordinary knowledge in the technical field to which the present disclosure pertains can easily practice the present disclosure. Furthermore, a singular form may include a plural form as long as it is not specifically mentioned in a sentence.

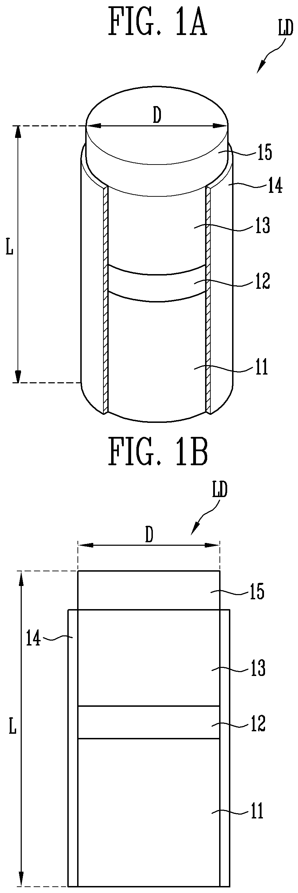

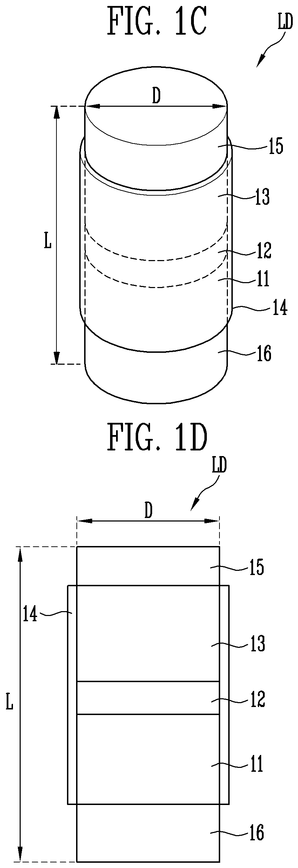

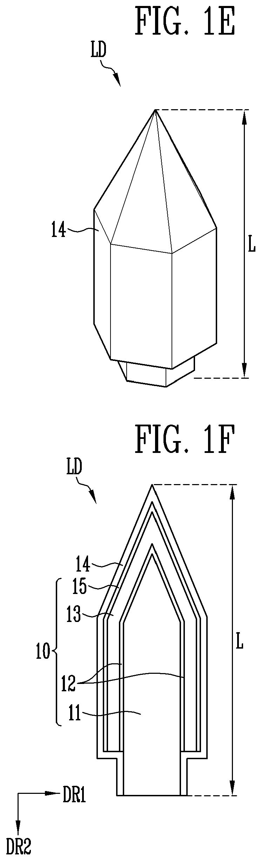

FIG. 1a is a perspective view schematically illustrating a light emitting element in accordance with an embodiment of the present disclosure. FIG. 1b is a schematic cross-sectional view illustrating the light emitting element of FIG. 1a. FIG. 1c is a perspective view schematically illustrating a light emitting element in accordance with an embodiment of the present disclosure. FIG. 1d is a schematic cross-sectional view illustrating the light emitting element of FIG. 1c. FIG. 1e is a perspective view schematically illustrating a light emitting element in accordance with an embodiment of the present disclosure. FIG. 1f is a schematic cross-sectional view illustrating the light emitting element of FIG. 1e.

For the sake of explanation, cylindrical light emitting elements will be described with reference to FIGS. 1a to 1d, and thereafter a light emitting element having a core-shell structure will be described with reference to FIGS. 1e and 1f. In an embodiment of the present disclosure, the type and/or shape of the light emitting element is not limited to the embodiments illustrated in FIGS. 1a to 1f.

Referring to FIGS. 1a to 1d, a light emitting element LD in accordance with an embodiment of the present disclosure may include a first conductive semiconductor layer 11, a second conductive semiconductor layer 13, and an active layer 12 interposed between the first and second conductive semiconductor layers 11 and 13. For example, the light emitting element LD may be implemented as an emission stack formed by successively stacking the first conductive semiconductor layer 11, the active layer 12, and the second conductive semiconductor layer 13.

In an embodiment of the present disclosure, the light emitting element LD may be formed in a shape extending in a direction. If the direction in which the light emitting element LD extends is defined as a longitudinal direction, the light emitting element LD may have a first end and a second end in the extension direction. One of the first and second conductive semiconductor layers 11 and 13 may be disposed on one end (or first end) of the light emitting element LD, and the other one of the first and second conductive semiconductor layers 11 and 13 may be disposed on the other end (or second end) of the light emitting element LD.

Although the light emitting element LD may be provided in the form of a cylinder, the shape of the light emitting element LD is not limited thereto. The light emitting element LD may have a rod-like shape or a bar-like shape extending in the longitudinal direction (i.e., to have an aspect ratio greater than 1). For example, the length L of the light emitting element LD in a longitudinal direction may be greater than a diameter D thereof (or a width of the cross-section thereof). The light emitting element LD may include a light emitting diode fabricated to have a subminiature size, e.g., with a length L and/or a diameter D corresponding to the micrometer scale or the nanometer scale.

In an embodiment of the present disclosure, the diameter D of the light emitting element LD may approximately range from 0.5 µm to 500 µm, and the length L thereof may approximately range from 1 µm to 10 µm. However, the size of the light emitting element LD is not limited thereto, and the size of the light emitting element LD may be changed to meet requirements (or design conditions) of a lighting device or a self-emissive display device to which the light emitting element LD is applied.

The first conductive semiconductor layer 11 may include, for example, at least one n-type semiconductor layer. For instance, the first conductive semiconductor layer 11 may include an n-type semiconductor layer which includes any semiconductor material of InAlGaN, GaN, AlGaN, InGaN, AlN, and InN, and is doped with a first conductive dopant such as Si, Ge, or Sn. However, the material forming the first conductive semiconductor layer 11 is not limited thereto, and the first conductive semiconductor layer 11 may be formed of various other materials.

The active layer 12 may be disposed on the first conductive semiconductor layer 11 and have a single or multiple quantum well structure. The location of the active layer 12 may be changed in various ways depending on the type of the light emitting element LD. The active layer 12 may emit light having a wavelength ranging from 400 nm to 900 nm, and use a double heterostructure. In an embodiment of the present disclosure, a cladding layer (not shown) doped with a conductive dopant may be formed on and/or under the active layer 12. For example, the cladding layer may be formed of an AlGaN layer or an InAlGaN layer. In an embodiment, a material such as AlGaN or AlInGaN may be used to form the active layer 12, and various other materials may be used to form the active layer 12.

If an electric field of a predetermined voltage or more is applied to the opposite ends of the light emitting element LD, the light emitting element LD emits light by recombination of electron-hole pairs in the active layer 12. Since light emission of the light emitting element LD can be controlled based on the foregoing principle, the light emitting element LD may be used as a light source of various light emitting devices as well as a pixel of the display device.

The second conductive semiconductor layer 13 may be disposed on the active layer 12 and include a semiconductor layer of a type different from that of the first conductive semiconductor layer 11. For example, the second conductive semiconductor layer 13 may include at least one p-type semiconductor layer. For instance, the second conductive semiconductor layer 13 may include a p-type semiconductor layer which includes any semiconductor material of InAlGaN, GaN, AlGaN, InGaN, AlN, and InN, and is doped with a second conductive dopant such as Mg. However, the material forming the second conductive semiconductor layer 13 is not limited thereto, and the second conductive semiconductor layer 13 may be formed of various other materials.

In an embodiment of the present disclosure, the light emitting element LD may further include an electrode layer 15 disposed on the second conductive semiconductor layer 13, as illustrated in FIGS. 1a and 1b, as well as the first conductive semiconductor layer 11, the active layer 12, and the second conductive semiconductor layer 13. Furthermore, in an embodiment, as shown in FIGS. 1c and 1d, the light emitting element LD may further include another electrode layer 16 disposed on one end of the first conductive semiconductor layer 11 as well as the electrode layer 15.

Although each of the electrode layers 15 and 16 may be formed of an ohmic contact electrode, the present disclosure is not limited thereto. The electrode layers 15 and 16 may include metal or a metal oxide. For example, chromium (Cr), titanium (Ti), aluminium (Al), gold (Au), nickel (Ni), ITO, and an oxide or alloy thereof may be used alone or in combination with each other. However, the present disclosure is not limited thereto.

Materials included in the respective electrode layers 15 and 16 may be equal to or different from each other. The electrode layers 15 and 16 may be substantially transparent or semitransparent. Therefore, light generated from the light emitting element LD may pass through the electrode layers 15 and 16 and then be emitted outside the light emitting element LD.

In an embodiment of the present disclosure, the light emitting element LD may further include an insulating film 14. However, in some embodiments, the insulating film 14 may be omitted, or may be provided to cover only some of the first conductive semiconductor layer 11, the active layer 12, and the second conductive semiconductor layer 13.

The insulating film 14 may prevent the active layer 12 from short-circuiting due to contacting a conductive material except the first conductive semiconductor layer 11 and the second conductive semiconductor layer 13. By virtue of the insulating film 14, occurrence of a defect on the surface of the light emitting element LD may be minimized, whereby the lifetime and efficiency of the light emitting element LD may be improved. In case that light emitting elements LD are disposed in close contact with each other, the insulating film 14 may prevent an undesired short-circuit from occurring between the light emitting elements LD. It is not limited whether the insulating film 14 is provided, so long as the active layer 12 can be prevented from short-circuiting with an external conductive material.

As illustrated in FIGS. 1a and 1b, the insulating film 14 may be provided on a portion of the light emitting element LD other than one of opposite ends of the light emitting element LD. In this case, the insulating film 14 may expose only the electrode layer 15 disposed on one end (or first end) of the second conductive semiconductor layer 13 of the light emitting element LD and enclose the overall side surfaces of the components other than the electrode layer 15. Here, the insulating film 14 may allow at least the opposite ends of the light emitting element LD to be exposed to the outside. For example, the insulating film 14 may allow not only the electrode layer 15 disposed on one end (or first end) of the second conductive semiconductor layer 13 but also one end (or first end) of the first conductive semiconductor layer 11 to be exposed to the outside. In an embodiment, the insulating film 14 may enclose overall outer circumferential surfaces of the components included in the light emitting element LD. For example, the insulating film 14 may enclose the respective outer circumferential surfaces of the first conductive semiconductor layer 11, the active layer 12, the second conductive semiconductor layer 13, and the electrode layer 15.

In an embodiment, as illustrated in FIGS. 1c and 1d, in case that the electrode layers 15 and 16 are disposed on the respective opposite ends of the light emitting element LD, the insulating film 14 may allow at least one area of each of the electrode layers 15 and 16 to be exposed to the outside. As another example, in an embodiment, the insulating film 14 may not be provided.

In an embodiment of the present disclosure, the insulating film 14 may include a transparent insulating material. For example, the insulating film 14 may include at least one insulating material selected from the group consisting of SiO₂, Si₃N₄, Al₂O₃, and TiO₂, but the disclosure is not limited thereto. In other words, various materials having insulating properties may be employed.

If the insulating film 14 is provided in the light emitting element LD, the active layer 12 may be prevented from short-circuiting with a first electrode and/or a second electrode, which are not illustrated. By virtue of the insulating film 14, occurrence of a defect on the surface of the light emitting element LD may be minimized, whereby the lifetime and efficiency of the light emitting element LD may be improved. In case that light emitting elements LD are disposed in close contact with each other, the insulating film 14 may prevent an undesired short-circuit from occurring between the light emitting elements LD.

The light emitting element LD may be employed as a light source for various display devices. The light emitting element LD may be fabricated by a surface treatment process. For example, each light emitting element LD may be surface-treated so that, in case that light emitting elements LD are mixed with a fluidic solution (or solvent) and supplied to each emission area (e.g., an emission area of each sub-pixel), the light emitting elements LD can be evenly dispersed rather than unevenly aggregating in the solution.

A light emitting device including the light emitting element LD described above may be used not only in a display device but also in various devices which require a light source. However, this is not part of the invention as claimed.

For instance, in case that light emitting elements LD are disposed in the emission area of each pixel of a display panel, the light emitting elements LD may be used as a light source of the pixel. However, the application field of the light emitting element LD is not limited to the above-mentioned examples. For example, the light emitting element LD may also be used in other types of devices such as a lighting device, which requires a light source.

Next, a light emitting element LD having a core-shell structure will be described with reference to FIGS. 1e and 1f. The following description of the light emitting element LD having a core-shell structure will be focused on differences from the above-mentioned embodiments, and components of the light emitting element LD that are not separately explained in the following description may comply with that of the preceding embodiments. The same reference numerals will be used to designate the same components, and similar reference numerals will be used to designate similar components.

Referring to FIGS. 1e and 1f, the light emitting element LD in accordance with an embodiment of the present disclosure may include a first conductive semiconductor layer 11, a second conductive semiconductor layer 13, and an active layer 12 interposed between the first and second conductive semiconductor layers 11 and 13. In some embodiments, the light emitting element LD may include a light emitting pattern 10 which has a core-shell structure and includes a first conductive semiconductor layer 11 disposed at the center, an active layer 12 which encloses at least one side of the first conductive semiconductor layer 11, a second conductive semiconductor layer 13 which encloses at least one side of the active layer 12, and an electrode layer 15 which encloses at least one side of the second conductive semiconductor layer 13.

The light emitting element LD may be formed in a polypyramid shape extending in a direction. In an embodiment of the present disclosure, the light emitting element LD may be provided in the form of a hexagonal pyramid. If the direction in which the light emitting element LD extends is defined as a longitudinal direction (L), the light emitting element LD may have a first end (or a lower end) and a second end (or an upper end) in the longitudinal direction (L). In an embodiment, one of the first and second conductive semiconductor layers 11 and 13 may be disposed at the first end (or the lower end) of the light emitting element LD. The other one of the first and second conductive semiconductor layers 11 and 13 may be disposed at the second end (or the upper end) of the light emitting element LD.

In an embodiment, the light emitting element LD may have a small size corresponding to the nanometer scale or the micrometer scale, e.g., a diameter and/or a length L having a nanometer scale range or a micrometer scale range. However, in the present disclosure, the size of the light emitting element LD is not limited thereto, and the size of the light emitting element LD may be changed to meet requirements (or application conditions) of a lighting device or a self-emissive display device to which the light emitting element LD is applied.

In an embodiment of the present disclosure, the first conductive semiconductor layer 11 may be disposed at a core, i.e., a central (or middle) portion of the light emitting element LD. The light emitting element LD may have a shape corresponding to the shape of the first conductive semiconductor layer 11. For instance, if the first conductive semiconductor layer 11 has a hexagonal pyramid shape, the light emitting element LD and the light emitting pattern 10 each may also have a hexagonal pyramid shape.

The active layer 12 may be provided and/or formed in a shape enclosing the outer circumferential surface of the first conductive semiconductor layer 11 in the longitudinal direction (L) of the light emitting element LD. In detail, the active layer 12 may be provided and/or formed in a shape enclosing an area of the first conductive semiconductor layer 11, other than the second end of the opposite ends of the first conductive semiconductor layer 11 that is disposed at the lower position in the longitudinal direction (L) of the light emitting element LD.

The second conductive semiconductor layer 13 may be provided and/or formed in a shape enclosing the active layer 12 in the longitudinal direction (L) of the light emitting element LD, and may include a semiconductor layer having a type different from that of the first conductive semiconductor layer 11. For example, the second conductive semiconductor layer 13 may include at least one p-type semiconductor layer.

In an embodiment of the present disclosure, the light emitting element LD may include an electrode layer 15 that encloses at least one side of the second conductive semiconductor layer 13. The electrode layer 15 may be an ohmic contact electrode electrically connected to the second conductive semiconductor layer 13, but the present disclosure is not limited thereto.

As described above, the light emitting element LD may have a hexagonal pyramid shape with the opposite ends protruding outward, and may be implemented as the light emitting pattern 10 having a core-shell structure including the first conductive semiconductor layer 11 provided at the central portion thereof, the active layer 12 which encloses the first conductive semiconductor layer 11, the second conductive semiconductor layer 13 which encloses the active layer 12, and the electrode layer 15 which encloses the second conductive semiconductor layer 13. The first conductive semiconductor layer 11 may be disposed in the first end (or the lower end) of the light emitting element LD having a hexagonal pyramid shape, and the electrode layer 15 may be disposed at the second end (or the upper end) of the light emitting element LD.

In an embodiment, the light emitting element LD may further include an insulating film 14 provided on the outer circumferential surface of the light emitting pattern 10 having a core-shell structure. The insulating film 14 may include a transparent insulating material.

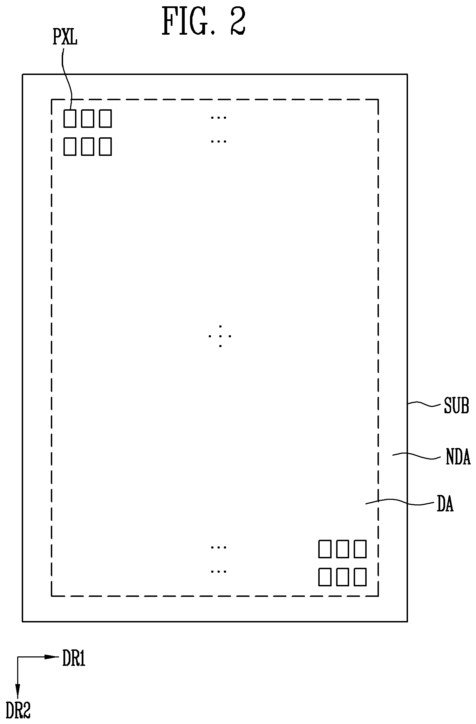

FIG. 2 illustrates a display device in accordance with an embodiment of the present invention, and particularly, is a schematic plan view illustrating a display device using any one light emitting element of the light emitting elements illustrated in FIGS. 1a to 1f as a light emitting source.

For the sake of explanation, FIG. 2 schematically illustrates the structure of the display device, focused on a display area in which an image is displayed. In some embodiments, although not illustrated in the drawings, at least one driving circuit (e.g., a scan driver and a data driver) and/or lines may be further provided in the display device.

Referring to FIGS. 1a to 1f, and 2, the display device in accordance an embodiment of the present invention includes a substrate SUB, pixels PXL provided on the substrate SUB and each including at least one light emitting element LD, a driver (not illustrated) provided on the substrate SUB and configured to drive the pixels PXL, and a line component (not illustrated) provided to electrically connect the pixels PXL with the driver.

The display device may be classified into a passive-matrix type display device and an active-matrix type display device according to a method of driving the light emitting element LD. For example, in case that the display device in accordance with an embodiment is implemented as an active matrix type, each of the pixels PXL may include a driving transistor configured to control the amount of current to be supplied to the light emitting element LD, and a switching transistor configured to transmit data signals to the driving transistor.

Recently, active-matrix type display devices capable of selectively turning on each pixel PXL taking into account the resolution, the contrast, and the working speed have been mainstreamed. However, the present disclosure is not limited thereto. For example, passive-matrix type display devices in which pixels PXL may be turned on by groups may also employ components (e.g., first and second electrodes) for driving the light emitting element LD.

The substrate SUB includes a display area DA and a non-display area NDA.

In an embodiment, the display area DA may be disposed in a central area of the display device, and the non-display area NDA may be disposed in a perimeter area of the display device in such a way as to enclose the display area DA. The locations of the display area DA and the non-display area NDA are not limited thereto, and the locations thereof may be changed.

The display area DA is an area in which the pixels PXL for displaying an image are provided. The non-display area NDA may be an area in which the driver for driving the pixels PXL and some of the line component for coupling (or connecting) the pixels PXL to the driver are provided.

The display area DA may have various shapes. For example, the display area DA may be provided in various forms such as a closed polygon including sides formed of linear lines, a circle, an ellipse or the like including a side formed of a curved line, and a semicircle, a semi-ellipse or the like including sides formed of a linear line and a curved line.

The non-display area NDA may be provided in at least one side of the display area DA. In an embodiment of the present disclosure, the non-display area NDA may enclose the perimeter of the display area DA.

The substrate SUB may include a transparent insulating material to allow light transmission.

The substrate SUB may be a rigid substrate. For example, the rigid substrate SUB may be one of a glass substrate, a quartz substrate, a glass ceramic substrate, and a crystalline glass substrate.

The substrate SUB may be a flexible substrate. Here, the flexible substrate SUB may be either a film substrate or a plastic substrate which includes a polymer organic material. For example, the flexible substrate SUB may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

However, materials forming (or constituting) the substrate SUB may be changed, and include, for example, fiber-reinforced plastic (FRP).

An area of the substrate SUB is provided as the display area DA in which the pixels PXL are disposed, and the other area thereof is provided as the non-display area NDA. For example, the substrate SUB may include the display area DA including pixel areas on which the respective pixels PXL are formed, and the non-display area NDA disposed around the display area DA.

The pixels PXL are disposed in the display area DA on the substrate SUB. In an embodiment of the present disclosure, the pixels PXL may be arranged in the display area DA in a stripe or a PENTILE^{™} arrangement structure, but the present disclosure is not limited thereto.

Each pixel PXL includes a light emitting element LD configured to be driven in response to a corresponding scan signal and a corresponding data signal. The light emitting element LD may have a small size corresponding to the nanometer or micrometer scale and be electrically connected in parallel to light emitting elements LD disposed adjacent thereto, but the present disclosure is not limited thereto. The light emitting element LD may form a light source of each pixel PXL.

Each of the pixels PXL may include at least one light source which is driven by a predetermined control signal (e.g., a scan signal and a data signal) and/or a predetermined power supply (e.g., a first driving power supply and a second driving power supply). For example, each of the pixels PXL may include a light emitting element LD illustrated in each of the embodiments of FIGS. 1a to 1f, e.g., at least one subminiature rod-type light emitting element LD having a small size corresponding to the nanometer scale or the micrometer scale. However, in embodiments of the present disclosure, the type of the light emitting element LD which may be used as a light source of the pixel PXL is not limited thereto.

In an embodiment of the present disclosure, the color, type, and/or number of pixels PXL are not particularly limited. For example, the color of light emitted from each pixel PXL may be changed in various ways.

The driver may provide a signal to each pixel PXL through the line component and thus control the operation of the pixel PXL. In FIG. 2, the line component is omitted for the convenience sake of explanation.

The driver may include a scan driver configured to provide scan signals to the pixels PXL through scan lines, an emission driver configured to provide emission control signals to the pixels PXL through emission control lines, a data driver configured to provide data signals to the pixels PXL through data lines, and a timing controller. The timing controller may control the scan driver, the emission driver, and the data driver.

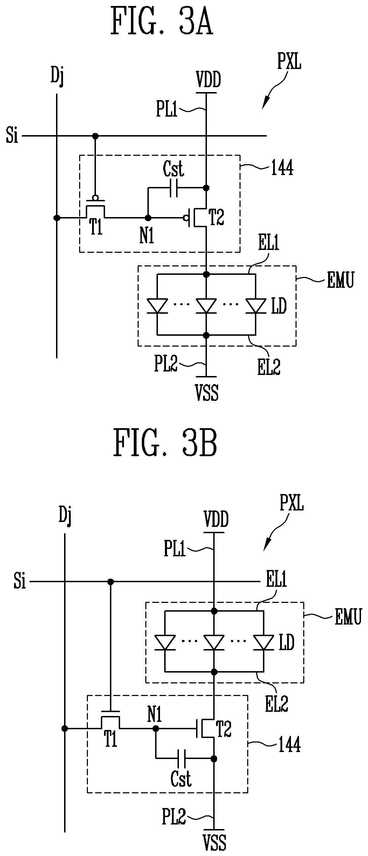

FIGS. 3a to 3c are schematic circuit diagrams illustrating various embodiments of electrical connection relationship of components included in any of the pixels illustrated in FIG. 2.

For example, FIGS. 3a to 3c illustrate different embodiments of the electrical connection relationship of components included in a pixel PXL which may be employed in an active display device. However, the types of the components included in the pixel PXL to which embodiments of the present disclosure may be applied are not limited thereto.

In FIGS. 3a to 3c, not only the components included in each of the pixels PXL illustrated in FIG. 2 but also an area in which the components are provided is embraced in the definition of the term "pixel PXL". In an embodiment, each pixel PXL illustrated in FIGS. 3a to 3c may be any of the pixels PXL provided in the display device of FIG. 2. The pixels PXL may have substantially the same or similar structure.

Referring to FIGS. 1a to 1f, 2, and 3a to 3c, each pixel PXL (hereinafter referred to as "pixel") may include an emission unit EMU configured to generate light having a luminance corresponding to a data signal. The pixel PXL may selectively further include a pixel circuit 144 configured to drive the emission unit EMU.

In an embodiment, the emission unit EMU may include light emitting elements LD electrically connected in parallel between a first power supply line PL1 to which a voltage of first driving power supply VDD is applied and a second power supply line PL2 to which a voltage of second driving power supply VSS is applied. For example, the emission unit EMU may include a first electrode EL1 (or "first alignment electrode") electrically connected to the first driving power supply VDD via the first power supply line PL1, a second electrode EL2 (or "second alignment electrode") electrically connected to the second driving power supply VSS through the second power supply line PL2, and light emitting elements LD electrically connected in parallel to each other in an identical direction between the first and second electrodes EL1 and EL2. In an embodiment of the present disclosure, the first electrode EL1 may be an anode electrode, and the second electrode EL2 may be a cathode electrode.

In an embodiment of the present disclosure, each of the light emitting elements LD included in the emission unit EMU may include a first end electrically connected to the first driving power supply VDD through the first electrode EL1, and a second end electrically connected to the second driving power supply VSS through the second electrode EL2. The first driving power supply VDD and the second driving power supply VSS may have different potentials. For example, the first driving power supply VDD may be set as a high-potential power supply, and the second driving power supply VSS may be set as a low-potential power supply. Here, a difference in potential between the first and second driving power supplies VDD and VSS may be set to a value equal to or greater than a threshold voltage of the light emitting elements LD during an emission period of the pixel PXL.

As described above, the light emitting elements LD that are electrically connected in parallel to each other in the same direction (e.g., in a forward direction) between the first electrode EL1 and the second electrode EL2 to which voltages having different potentials are respectively supplied may form respective valid light sources. The valid light sources may collectively form the emission unit EMU of the pixel PXL.

The light emitting elements LD of the emission unit EMU may emit light having a luminance corresponding to driving current supplied thereto through the pixel circuit 144. For example, during each frame period, the pixel circuit 144 may supply driving current corresponding to a grayscale of corresponding frame data to the emission unit EMU. The driving current supplied to the emission unit EMU may be divided into the light emitting elements LD electrically connected to each other in the identical direction. Hence, each of the light emitting elements LD may emit light having a luminance corresponding to current applied thereto, so that the emission unit EMU may emit light having a luminance corresponding to the driving current.

Although FIGS. 3a to 3c illustrate embodiments in which the light emitting elements LD are electrically connected to each other in the identical direction between the first and second driving power supplies VDD and VSS, the present disclosure is not limited thereto. In an embodiment, the emission unit EMU may further include at least one invalid light source, as well as the light emitting elements LD that form the respective valid light sources. For example, at least a reverse light emitting element (not shown) may be further electrically connected between the first and second electrodes EL1 and EL2 of the emission unit EMU. The reverse light emitting element, along with the light emitting elements LD that form the valid light sources, may be electrically connected in parallel to each other between the first and second electrodes EL1 and EL2. Here, the reverse light emitting element may be electrically connected between the first and second electrodes EL1 and EL2 in a direction opposite to that of the light emitting elements LD. Even in case that a predetermined driving voltage (e.g., a normal directional driving voltage) is applied between the first and second electrodes EL1 and EL2, the reverse light emitting element remains disabled. Hence, current does not substantially flow through the reverse light emitting element.

The pixel circuit 144 may be electrically connected to a scan line Si and a data line Dj of the corresponding pixel PXL. For example, if the pixel PXL is disposed in an i-th row (where i is a natural number) and a j-th column (where j is a natural number) of the display area DA, the pixel circuit 144 of the pixel PXL may be electrically connected to an i-th scan line Si and a j-th data line Dj of the display area DA. In an embodiment, the pixel circuit 144 may include first and second transistors T1 and T2, and a storage capacitor Cst, as illustrated in FIG. 3a. However, the structure of the pixel circuit 144 is not limited to that of the embodiment illustrated in FIG. 3a.

A first terminal of the first transistor T1(switching transistor) may be electrically connected to the data line Dj, and a second terminal thereof may be electrically connected to a first node N1. Here, the first terminal and the second terminal of the first transistor T1 are different from each other, and, for example, in case that the first terminal is a source electrode, the second terminal is a drain electrode. A gate electrode of the first transistor T1 may be electrically connected to the scan line Si.

In case that a scan signal having a voltage (e.g., a low-level voltage) capable of turning on the first transistor T1 is supplied from the scan line Si, the first transistor T1 is turned on to electrically connect the data line Dj with the first node N1. Here, a data signal of a corresponding frame is supplied to the data line Dj, whereby the data signal is transmitted to the first node N1. The data signal transmitted to the first node N1 may be charged to the storage capacitor Cst.

A first terminal of the second transistor T2 (driving transistor) may be electrically connected to the first driving power supply VDD, and a second terminal thereof may be electrically connected to the first electrode EL1 for the light emitting elements LD. A gate electrode of the second transistor T2 may be electrically connected to the first node N1. As such, the second transistor T2 may control the amount of driving current to be supplied to the light emitting elements LD in response to the voltage of the first node N1.

A first electrode of the storage capacitor Cst may be electrically connected to the first driving power supply VDD, and a second electrode thereof may be electrically connected to the first node N1. The storage capacitor Cst is charged with a voltage corresponding to a data signal supplied to the first node N1, and maintains the charged voltage until a data signal of a subsequent frame is supplied.

FIG. 3a illustrates the pixel circuit 144 including the first transistor T1 configured to transmit a data signal to the pixel PXL, the storage capacitor Cst configured to store the data signal, and the second transistor T2 configured to supply driving current corresponding to the data signal to the light emitting elements LD.

However, the present disclosure is not limited thereto, and the structure of the pixel circuit 144 may be changed in various ways. For example, the pixel circuit 144 may further include at least one transistor element such as a transistor element configured to compensate for the threshold voltage of the second transistor T2, a transistor element configured to initialize the first node N1, and/or a transistor element configured to control an emission time of the light emitting elements LD, or other circuit elements such as a boosting capacitor for boosting the voltage of the first node N1.

Furthermore, although in FIG. 3a the transistors, e.g., the first and second transistors T1 and T2, included in the pixel circuit 144 are illustrated as being formed of P-type transistors, the present disclosure is not limited thereto. In other words, at least one of the first and second transistors T1 and T2 included in the pixel circuit 144 may be changed to an N-type transistor.

Next, referring to FIGS. 1a to 1f, 2, and 3b, the first and second transistors T1 and T2 in accordance with an embodiment of the present disclosure may be formed of N-type transistors. The configuration and operation of the pixel circuit 144 illustrated in FIG. 3b may be different from those of the pixel circuit 144 of FIG. 3a at least in a change in connection positions of some components due to a change in the type of transistor. Therefore, detailed descriptions thereof will be omitted below.

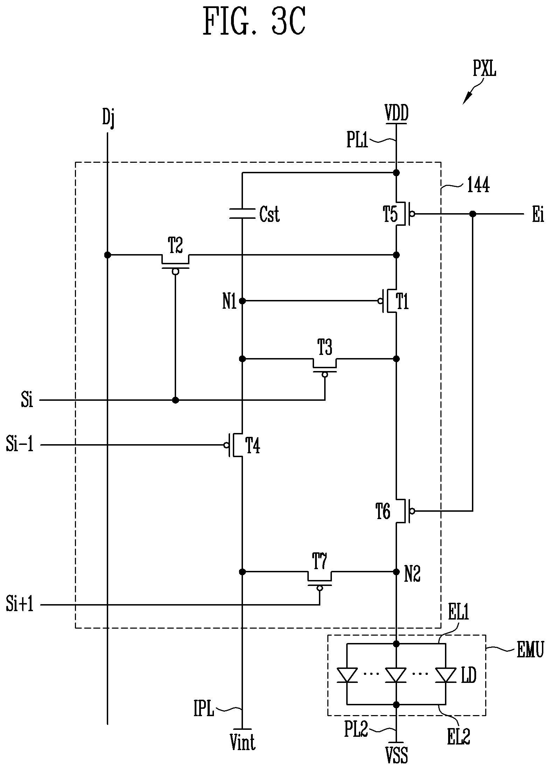

In an embodiment of the present disclosure, the configuration of the pixel circuit 144 is not limited to the embodiments illustrated in FIGS. 3a and 3b. For example, the pixel circuit 144 may be configured in the same manner as that of an embodiment shown in FIG. 3c.

As illustrated in FIG. 3c, the pixel circuit 144 may be electrically connected to a scan line Si and a data line Dj of the pixel PXL. For example, if the pixel PXL is disposed in an i-th row and a j-th column of the display area DA, the pixel circuit 144 of the pixel PXL may be electrically connected to an i-th scan line Si and a j-th data line Dj of the display area DA.

In an embodiment, the pixel circuit 144 may also be electrically connected to at least one scan line. For example, the pixel PXL disposed in the i-th row of the display area DA may also be electrically connected to an i-1-th scan line Si-1 and/or an i+1-th scan line Si+1. In an embodiment, the pixel circuit 144 may be electrically connected not only to the first and second driving power supplies VDD and VSS but also to a third power supply. For example, the pixel circuit 144 may be electrically connected to an initialization power supply Vint.

The pixel circuit 144 may include first to seventh transistors T1 to T7, and a storage capacitor Cst.

A first electrode, e.g., a source electrode, of the first transistor T1 (driving transistor) may be electrically connected to the first driving power supply VDD via the fifth transistor T5, and a second electrode thereof, e.g., a drain electrode, may be electrically connected to one ends of light emitting elements LD via the sixth transistor T6. A gate electrode of the first transistor T1 may be electrically connected to a first node N1. The first transistor T1 may control driving current flowing between the first driving power supply VDD and the second driving power supply VSS via the light emitting elements LD in response to the voltage of the first node N1.

The second transistor T2 (switching transistor) may be electrically connected between the j-th data line Dj electrically connected to the pixel PXL and the source electrode of the first transistor T1. A gate electrode of the second transistor T2 may be electrically connected to the i-th scan line Si electrically connected to the pixel PXL. In case that a scan signal having a gate-on voltage (e.g., a low-level voltage) is supplied from the i-th scan line Si, the second transistor T2 may be turned on to electrically connect the j-th data line Dj to the source electrode of the first transistor T1. Hence, if the second transistor T2 is turned on, a data signal supplied from the j-th data line Dj may be transmitted to the first transistor T1.

The third transistor T3 may be electrically connected between the drain electrode of the first transistor T1 and the first node N1. A gate electrode of the third transistor T3 may be electrically connected to the i-th scan line Si. In case that a scan signal having a gate-on voltage is supplied from the i-th scan line Si, the third transistor T3 may be turned on to electrically connect the drain electrode of the first transistor T1 to the first node N1.

The fourth transistor T4 may be electrically connected between the first node N1 and an initialization power supply line IPL to which a voltage of the initialization power supply Vint is to be applied. A gate electrode of the fourth transistor T4 may be electrically connected to a preceding scan line, e.g., the i-1-th scan line Si-1. In case that a scan signal having a gate-on voltage is supplied to the i-1-th scan line Si-1, the fourth transistor T4 may be turned on so that the voltage of the initialization power supply Vint may be transmitted to the first node N1. Here, the initialization power supply Vint may have a voltage equal to or less than the minimum voltage of the data signal.

The fifth transistor T5 may be electrically connected between the first driving power supply VDD and the first transistor T1. A gate electrode of the fifth transistor T5 may be electrically connected to a corresponding emission control line, e.g., an i-th emission control line Ei. The fifth transistor T5 may be turned off in case that an emission control signal having a gate-off voltage is supplied to the i-th emission control line Ei, and may be turned on in other cases.

The sixth transistor T6 may be electrically connected between the first transistor T1 and the first ends of the light emitting elements LD. A gate electrode of the sixth transistor T6 may be electrically connected to the i-th emission control line Ei. The sixth transistor T6 may be turned off in case that an emission control signal having a gate-off voltage is supplied to the i-th emission control line Ei, and may be turned on in other cases.

The seventh transistor T7 may be electrically connected between the initialization power supply line IPL and a second node N2. A gate electrode of the seventh transistor T7 may be electrically connected to any one of the scan lines of a subsequent stage, e.g., to the i+1-th scan line Si+1. In case that a scan signal having a gate-on voltage is supplied to the i+1-th scan line Si+1, the seventh transistor T7 may be turned on so that the voltage of the initialization power supply Vint may be supplied to the first ends of light emitting elements LD.

The storage capacitor Cst may be electrically connected between the first driving power supply VDD and the first node N1. The storage capacitor Cst may store a voltage corresponding both to the data signal applied to the first node N1 during each frame period and to the threshold voltage of the first transistor T1.

Although in FIG. 3c the transistors included in the pixel circuit 144, e.g., the first to seventh transistors T1 to T7, are illustrated as being formed of P-type transistors, the present disclosure is not limited thereto. For example, at least one of the first to seventh transistors T1 to T7 may be changed to an N-type transistor.

Although FIGS. 3a to 3c illustrate embodiments in which all light emitting elements LD of each emission unit EMU are electrically connected in parallel to each other, the present disclosure is not limited thereto. In an embodiment, the emission unit EMU may include at least one serial stage including a plurality of light emitting elements LD electrically connected in parallel to each other. In other words, the emission unit EMU may be formed in a serial/parallel combination structure.

The structure of the pixel PXL which may be applied to the present disclosure is not limited to the embodiments illustrated in FIGS. 3a to 3c, and the corresponding pixel PXL may have various structures. In an embodiment of the present disclosure, each pixel PXL may be configured in a passive light emitting display device, or the like. In this case, the pixel circuit 144 may be omitted, and the opposite ends of the light emitting elements LD included in the emission unit EMU may be directly electrically connected to the scan lines Si-1, Si, and Si+1, the data line Dj, the first power supply line PL1 to which a voltage of the first driving power supply VDD is to be applied, the second power supply line PL2 to which a voltage of the second driving power supply VSS is to be applied, and/or a predetermined control line.

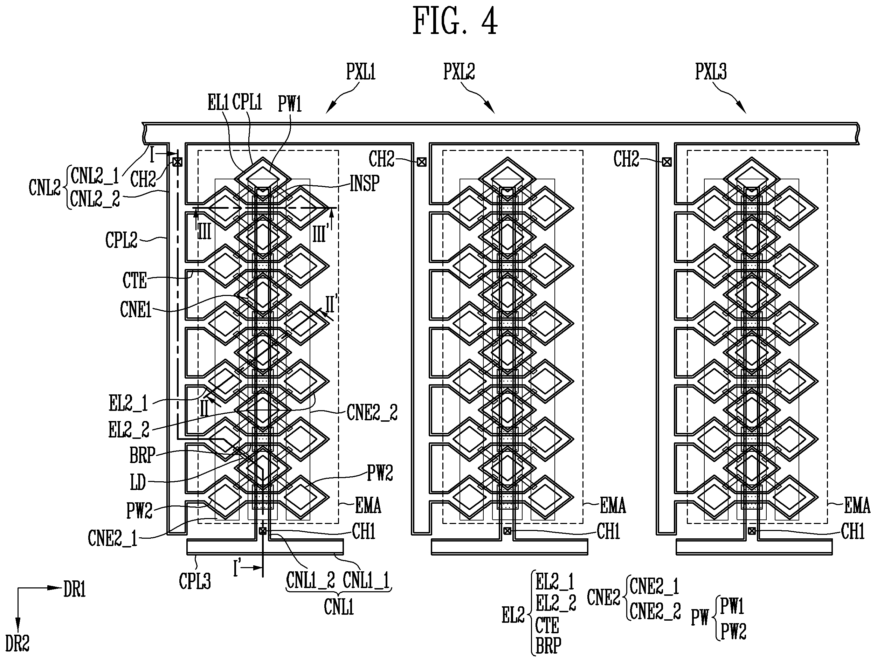

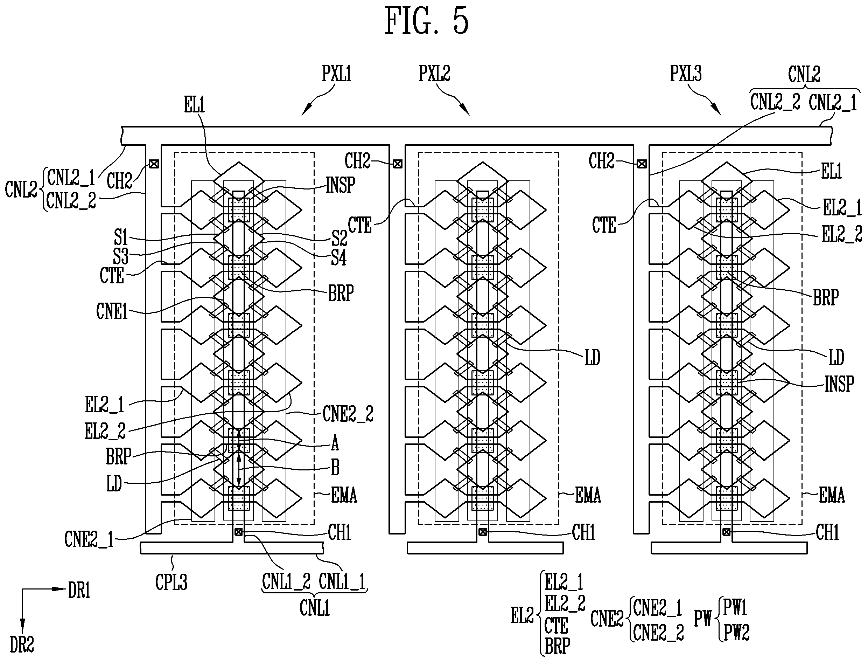

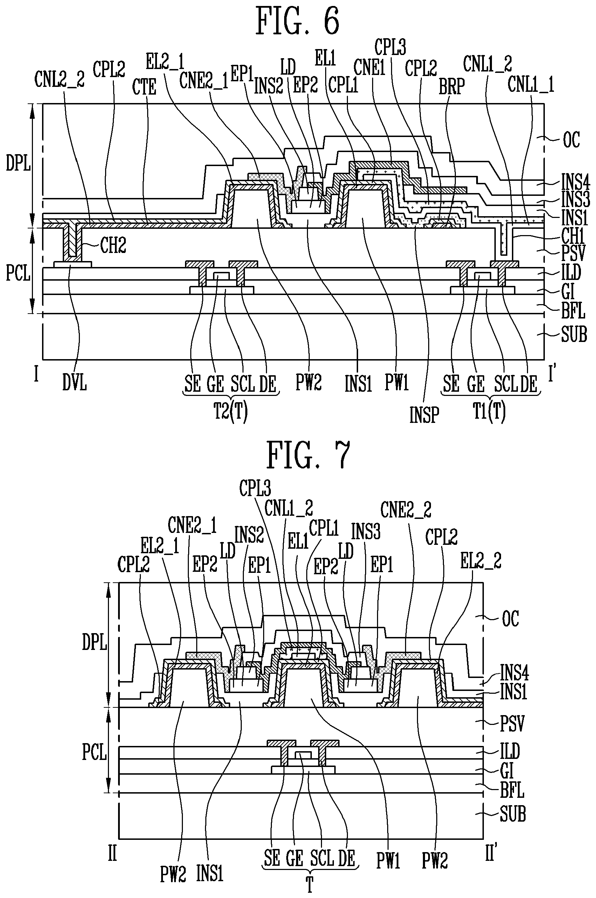

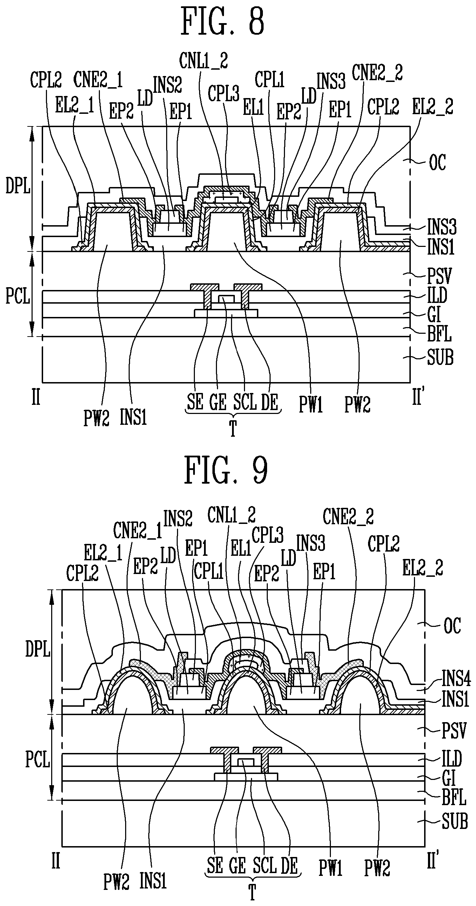

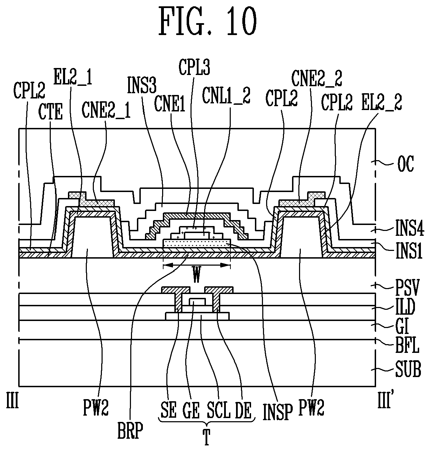

FIG. 4 is a plan view schematically illustrating three pixels adjacent to each other in a row direction among the pixels shown in FIG. 2. FIG. 5 is a schematic plan view illustrating only first and second electrodes and light emitting elements aligned therebetween among first to third pixels of FIG. 4. FIG. 6 is a schematic cross-sectional view taken along line I-I' of FIG. 4. FIG. 7 is a schematic cross-sectional view taken along line II-II' of FIG. 4. FIG. 8 illustrates an embodiment in which the first and second electrodes shown in FIG. 7 are disposed on an identical layer, and is a schematic cross-sectional view corresponding to line II-II' of FIG. 4. FIG. 9 illustrates another shape of a partition wall (or bank pattern) illustrated in FIG. 7, and is a schematic cross-sectional view corresponding to line II-II' of FIG. 4. FIG. 10 is a schematic cross-sectional view taken along line III-III' of FIG. 4.

In FIGS. 4 and 5, for the sake of explanation, illustration of transistors electrically connected to the light emitting elements, and signal lines electrically connected to the transistors is omitted.

The first to third pixels shown in each of FIGS. 4 and 5 may refer to three pixels adjacent to each other in a first direction. Here, the first pixel of the first to third pixels may refer to a pixel disposed in a j-th column of an i-th row. The second pixel may refer to a pixel disposed in a j+1-th column of the i-th row. The third pixel may refer to a pixel disposed in a j+2-th column of the i-th row.

Moreover, although FIGS. 4 to 10 illustrate a simplified structure of each of the first to third pixel, e.g., showing that each electrode has only a single electrode layer, and each insulating layer has only a single insulating layer, the present disclosure is not limited thereto.

Furthermore, in an embodiment of the present disclosure, the term "pixel PXL" or "pixels PXL" will be used to designate at least one or more pixels of the first to third pixels. In an embodiment of the present disclosure, the words "components are provided and/or formed on the same layer" may mean that the components are formed by an identical process.

Referring to FIG. 1a to 10, the display device in accordance with an embodiment of the present invention includes a substrate SUB on which first to third pixels PXL1, PXL2, and PXL3 are provided.

In an embodiment of the present disclosure, the first pixel PXL1 may be a red pixel, the second pixel PXL2 may be a green pixel, and the third pixel PXL3 may be a blue pixel. However, the present disclosure is not limited thereto. In an embodiment, the first pixel PXL1 may be a green pixel or a blue pixel, the second pixel PXL2 may be a blue pixel or a red pixel, and the third pixel PXL3 may be a red pixel or a green pixel.

Each of the first to third pixels PXL1 to PXL3 includes an emission area EMA configured to emit light, and a peripheral area disposed around a perimeter of the emission area EMA. The emission area EMA may refer to an area from which light is emitted, and the peripheral area may refer to an area from which the light is not emitted. In an embodiment of the present disclosure, a pixel area of each of the first to third pixels PXL1 to PXL3 may include an emission area EMA and a peripheral area of the corresponding pixel.

A substrate SUB, a pixel circuit layer PCL, and a display element layer DPL may be provided in the pixel area of each of the first to third pixels PXL1 to PXL3.

The pixel circuit layer PCL of each of the first to third pixels PXL1 to PXL3 may include a buffer layer BFL disposed on the substrate SUB, at least one transistor T disposed on the buffer layer BFL, and a driving voltage line DVL. Furthermore, the pixel circuit layer PCL of each of the first to third pixels PXL1 to PXL3 may further include a passivation layer PSV which is provided on the transistor T and the driving voltage line DVL.

The substrate SUB may be a rigid substrate or a flexible substrate.

The buffer layer BFL may prevent impurities from diffusing into the transistor T. The buffer layer BFL may be provided in a single layer structure or a multi-layer structure having at least two or more layers. In case that the buffer layer BFL has a multi-layer structure, the respective layers may be formed of an identical material or different materials. The buffer layer BFL may be omitted depending on the material of the substrate SUB and/or processing conditions.

The transistor T may include a first transistor T1 (T) and a second transistor T2 (T). In an embodiment of the present disclosure, the first transistor T1 (T) may be a driving transistor electrically connected to light emitting elements LD of a corresponding pixel PXL and configured to drive the light emitting elements LD. The second transistor T2 (T) may be a switching transistor configured to switch the first transistor T1 (T).

Each of the first transistor T1 (T) and the second transistor T2 (T) may include a semiconductor layer SCL, a gate electrode GE, a first terminal SE, and a second terminal DE. The first terminal SE may be either a source electrode or a drain electrode, and the second terminal DE may be the other electrode. For example, in case that the first terminal SE is the source electrode, the second terminal DE may be the drain electrode.

The semiconductor layer SCL may be disposed on the buffer layer BFL. The semiconductor layer SCL may include a first area which contacts the first terminal SE and a second area which contacts the second terminal DE. An area between the first area and the second area may be a channel area.

The semiconductor layer SCL may be a semiconductor pattern formed of polysilicon, amorphous silicon, an oxide semiconductor, etc. The channel area may be an intrinsic semiconductor, which is an undoped semiconductor pattern. The first area and the second area each may be a semiconductor pattern doped with impurities.

The gate electrode GE may be provided on the semiconductor layer SCL with a gate insulating layer GI interposed therebetween.

Each of the first terminal SE and the second terminal DE may respectively contact the first area and the second area of the semiconductor layer SCL through corresponding contact holes that pass through an interlayer insulating layer ILD and the gate insulating layer GI.

In an embodiment of the present disclosure, at least one transistor T included in the pixel circuit layer PCL of each of the first to third pixels PXL1 to PXL3 may be formed of an LTPS thin-film transistor, but the present disclosure is not limited thereto. In some embodiments, the at least one transistor T may be formed of an oxide semiconductor thin-film transistor. Furthermore, in an embodiment of the present disclosure, the transistor T is illustrated as being a thin film transistor having a top gate structure, but the present disclosure is not limited thereto. In an embodiment, the transistor T may be a thin film transistor having a bottom gate structure.

The driving voltage line DVL may be provided on the interlayer insulating layer ILD, but the present disclosure is not limited thereto. In some embodiments, the driving voltage line DVL may be provided on any of the insulating layers included in the pixel circuit layer PCL. The voltage of the second driving power supply (VSS of FIG. 3a) may be applied to the driving voltage line DVL. In an embodiment of the present disclosure, the driving voltage line DVL may be the second power line PL2 to which the voltage of the second driving power supply VSS is applied, as illustrated in each of FIGS. 3a to 3c.

The passivation layer PSV may include a first contact hole CH1 which exposes a portion of the second terminal DE of the first transistor T1 (T), and a second contact hole CH2 which exposes a portion of the driving voltage line DVL.

The display element layer DPL of each of the first to third pixels PXL1 to PXL3 may include a partition wall PW, first electrodes EL1, second electrodes EL2, first and second connection lines CNL1 and CNL2, and first to third capping layers CPL1 to CPL3. In addition, the display element layer DPL of each of the first to third pixels PXL1 to PXL3 may selectively further include at least one first contact electrode CNE1 which is directly electrically connected to the first electrodes EL1 and at least one second contact electrode CNE2 which is directly electrically connected to the second electrodes EL2.

The partition wall PW may be a support or an insulating pattern which supports each of the first and second electrodes EL1 and EL2 so as to change a surface profile of each of the first and second electrodes EL1 and EL2 so that light emitted from the light emitting elements LD can more effectively travel in an image display direction of the display device.

The partition wall PW may be provided and/or formed on the passivation layer PSV of the emission area EMA of each of the first to third pixels PXL1 to PXL3. The partition wall PW may include an inorganic insulating layer formed of an inorganic material or an organic insulating layer formed of an organic material. In an embodiment, the partition wall PW may include a single organic insulating layer and/or a single inorganic insulating layer, but the present disclosure is not limited thereto. For example, the partition wall PW may have a multi-layer structure formed by stacking at least one or more organic insulating layers and at least one or more inorganic insulating layers.

The partition wall PW may have a trapezoidal cross-section, a width of which reduces from a surface of the passivation layer PSV upward, but the present disclosure is not limited thereto. In an embodiment, the partition wall PW may include a curved surface and have a cross-section having a semi-elliptical shape, a semi-circular shape, etc., a width of which reduces upward from a surface of the passivation layer PSV, as illustrated in FIG. 9. In a cross-sectional view, the shape of each of the partition walls PW is not limited to the foregoing examples, and may be changed in various ways within a range in which the efficiency of light emitted from each of the light emitting elements LD can be enhanced. The partition walls PW that are adjacent to each other may be disposed on the same plane on the passivation layer PSV and have the same height.

In an embodiment of the present disclosure, the partition wall PW may include a first partition wall (or first bank pattern) PW1 disposed under each of the first electrodes EL1, and a second partition wall (or second bank pattern) PW2 disposed under each of the second electrodes EL2. The first partition wall PW1 and the second partition wall PW2 may be disposed on a surface of the passivation layer PSV at positions spaced apart from each other by a predetermined distance.

The first partition wall PW1 may be disposed on the passivation layer PSV at a position spaced apart from the adjacent first partition wall PW1 in a second direction DR2 (e.g., "column direction"). The second partition wall PW2 may also be disposed on the passivation layer PSV at a position spaced apart from the adjacent second partition wall PW2 in the second direction DR2.

The display element layer DPL of each of the first to third pixels PXL1 to PXL3 may further include a bank (not illustrated) disposed, to enclose the emission area EMA of the corresponding pixel PXL, in the peripheral area (e.g., a non-emission area in which the light emitting elements LD are not disposed) of the corresponding pixel PXL. The bank may be a structure configured to define (or partition) the emission area EMA of each of the first to third pixels PXL1 to PXL3 and, for example, may be a pixel defining layer. The bank may include at least one light shielding material and/or reflective material and thus prevent a light leakage defect, in which light (or rays) leaks between adjacent pixels PXL, from occurring.

In an embodiment, a reflective material layer may be formed on the bank so as to further enhance the efficiency of light emitted from each of the pixels PXL. Although the bank may be formed and/or provided on a layer different from that of the partition wall PW, the present disclosure is not limited thereto. In an embodiment, the bank may be formed and/or provided on a layer identical to that of the partition wall PW.

The first connection line CNL1 may be provided and/or formed, to independently drive each of the first to third pixels PXL1 to PXL3 from adjacent pixels PXL, in only the corresponding pixel PXL, and electrically and/or physically separated from the first connection line CNL1 provided and/or formed in each of the adjacent pixels PXL.

In an embodiment of the present disclosure, the first connection line CNL1 may include a 1-1-th connection line CNL1_1 extending in the first direction DR1 (e.g., "row direction") and a 1-2-th connection line CNL1_2 extending in the second direction DR2 in each of the first to third pixels PXL1 to PXL3. In detail, the 1-1-th connection line CNL1_1 and the 1-2-th connection line CNL1_2 may be integral with each other and electrically and/or physically connected to each other. In case that the 1-1-th connection line CNL1_1 and the 1-2-th connection line CNL1_2 are integral with each other, the 1-1-th connection line CNL1_1 may be an area of the 1-2-th connection line CNL1_2, or the 1-2-th connection line CNL1_2 may be an area of the 1-1-th connection line CNL1_1.

The 1-2-th connection line CNL1_2 may be electrically and/or physically connected with the first electrodes EL1. The 1-2-th connection line CNL1_2 may be disposed on the first electrodes EL1 with an insulating pattern INSP interposed therebetween, and overlap the first electrodes EL1. The 1-2-th connection line CNL1_2 may include a first part A corresponding to the insulating pattern INSP, and a second part B other than the first part A. The second part B of the 1-2-th connection line CNL1_2 is a part corresponding to the first electrodes EL1, and a part electrically and/or physically connected with the first electrodes EL1.

The 1-2-th connection line CNL1_2 may be electrically connected to the second terminal DE of the first transistor T1 (T) of the pixel circuit layer PCL of each of the first to third pixels PXL1 to PXL3 through the first contact hole CH1 passing through the passivation layer PSV. Hence, a signal (or a voltage) applied to the first transistor T1 (T) may be transmitted to the 1-2-th connection line CNL1_2 of the corresponding pixel PXL.

The second connection line CNL2 may be provided in common to the first to third pixels PXL1 to PXL3. The first to third pixels PXL1 to PXL3 disposed in an identical row in the first direction DR1 may be electrically connected in common to the second connection line CNL2. The second connection line CNL2 may be electrically connected to the driving voltage line DVL of the pixel circuit layer PCL of each of the first to third pixels PXL1 to PXL3 through the second contact hole CH2 passing through the passivation layer PSV. Hence, a voltage of a second driving power supply voltage VSS applied to the driving voltage line DVL may be transmitted to the second connection line CNL2 provided in common to the first to third pixels PXL1 to PXL3.

In an embodiment of the present disclosure, the second connection line CNL2 may include a 2-1-th connection line CNL2_1 extending in the first direction DR1 and a 2-2-th connection line CNL2_2 extending in the second direction DR2 in each of the first to third pixels PXL1 to PXL3. In detail, the 2-1-th connection line CNL2_1 and the 2-2-th connection line CNL2_2 may be integral with each other and electrically and/or physically connected to each other. In case that the 2-1-th connection line CNL2_1 and the 2-2-th connection line CNL2_2 are integral with each other, the 2-1-th connection line CNL2_1 may be an area of the 2-2-th connection line CNL2_2, or the 2-2-th connection line CNL2_2 may be an area of the 2-1-th connection line CNL2_1.

In an embodiment of the present disclosure, the first connection line CNL1 and the second connection line CNL2 may be provided on respective layers different from each other. In detail, the first connection line CNL1 may be provided and/or formed on the first electrodes EL1. The second connection line CNL2 may be provided on a layer identical to that of the first electrodes EL1. In an embodiment of the present disclosure, the words "provided and/or formed on different layers" may mean that components are formed by different processes.

Each of the first and second electrodes EL1 and EL2 is provided in the emission area EMA of each of the first to third pixels PXL1 to PXL3 and disposed in the second direction DR2. The first electrodes EL1 and the second electrodes EL2 are provided on an identical surface and spaced apart from each other by a predetermined distance. In a plan view, the first electrodes EL1 and the second electrodes EL2 are alternately disposed in the second direction DR2. For example, the first electrodes EL1 may be disposed in odd-number-th rows in the emission area EMA of each of the first to third pixels PXL1 to PXL3, and the second electrodes EL2 may be disposed in even-number-th rows in the emission area EMA of the corresponding pixel PXL.

The first electrodes EL1 is disposed in the second direction DR2. Each of the first electrodes EL1 is spaced apart from an adjacent first electrode EL1 in the second direction DR2. In other words, each of the first electrodes EL1 may be physically separated from the adjacent first electrode EL1 in the second direction DR2. The first electrodes EL1 disposed in the second direction DR2 are electrically connected to each other by the first connection line CNL1. In an embodiment of the present disclosure, the first connection line CNL1 may be provided and/or formed on the first electrodes EL1 to electrically connect the first electrodes EL1 that are adjacent to each other in the second direction DR2. A signal (or a voltage) applied to the first connection line CNL1 may be transmitted to each of the first electrodes EL1 that are electrically connected to each other by the first connection line CNL1.

Although, in an embodiment of the present disclosure, each of the first electrodes EL1 may have a rhombic shape including four sides in a plan view, the present disclosure is not limited thereto. In an embodiment, the shape of the first electrodes EL1 may be changed in various ways. Each of the first electrodes EL1 may have a surface profile corresponding to a shape of the first partition wall PW disposed therebelow. Each of the first electrodes EL1 may have a surface area which is broad (or large) enough to completely cover the first partition wall PW1.

The second electrodes EL2 is disposed in the second direction DR2. In an embodiment of the present disclosure, the second electrodes EL2 may be provided on a layer identical to that of the second connection line CNL2, and electrically and/or physically connected with a second electrode EL2 adjacent thereto in the second direction DR2 by the second connection line CNL2. In other words, each of the second electrodes EL2 may be electrically and/or physically connected with the adjacent second electrode EL2 in the second direction DR2 by the second connection line CNL2.

In an embodiment of the present disclosure, each of the second electrodes EL2 may be integral with the second connection line CNL2, and electrically and/or physically connected to the second connection line CNL2. In case that the second connection line CNL2 and the second electrodes EL2 are integral with each other, the second connection line CNL2 may be provided as predetermined areas of the second electrodes EL2, or the second electrodes EL2 may be provided as predetermined areas of the second connection line CNL2. The second electrodes EL2 may diverge from the 2-2-th connection line CNL2_2 in the first direction DR1. As described above, since the second connection line CNL2 and the second electrodes EL2 are electrically connected to each other, a voltage of a second driving power supply VSS applied to the second connection line CNL2 may be transmitted to each of the second electrodes EL2.

In the present invention each of the second electrodes EL2 may include an intermediate electrode CTE, at least one bridge pattern BRP, and at least one or more sub-electrodes.

The sub-electrode of each of the second electrodes EL2 includes a first sub-electrode EL2_1 and a second sub-electrode EL2_2 which are disposed in the first direction DR1 and electrically and/or physically connected by the bridge pattern BRP. Although for the sake of explanation FIGS. 4 and 5 illustrate that each of the second electrodes EL2 includes only two sub-electrodes EL2_1 and EL2_2, the present disclosure is not limited thereto. In an embodiment, each of the second electrodes EL2 may include at least two or more sub-electrodes. In case that each of the second electrodes EL2 includes at least two or more sub-electrodes, e.g., three sub-electrodes, each of the second electrodes EL2 may include two bridge patterns BRP configured to connect the three sub-electrodes.

Each of the second electrodes EL2 includes i (where i is a natural number of one or more) bridge patterns BRP and i+1 (where i is a natural number of one or more) sub-electrodes.

The intermediate electrode CTE of each of the second electrodes EL2 may be an intermediate medium configured to electrically and/or physically connect the 2-2-th connection line CNL2 2 and the first sub-electrode EL2 1. One end of the intermediate electrode CTE of each of the second electrodes EL2 may be electrically connected to the 2-2-th connection line CNL2_2, and the other end thereof may be electrically connected to the first sub-electrode EL2 1. In an embodiment of the present disclosure, the intermediate electrode CTE of each of the second electrodes EL2 may be provided and/or formed integrally with the 2-2-th connection line CNL2_2. In this case, the intermediate electrode CTE of each of the second electrodes EL2 may be a predetermined area of the 2-2-th connection line CNL2_2.

The bridge pattern BRP of each of the second electrodes EL2 may be an intermediate medium which is disposed between the first sub-electrode EL2_1 and the second sub-electrode EL2_2 and configured to electrically and/or physically connect the first sub-electrode EL2_1 and the second sub-electrode EL2_2. One end of the bridge pattern BRP of each of the second electrodes EL2 may be electrically connected to the first sub-electrode EL2_1, and the other end thereof may be electrically connected to the second sub-electrode EL2_2. In an embodiment of the present disclosure, the bridge pattern BRP of each of the second electrodes EL2 may be provided and/or formed integrally with the first and second sub-electrodes EL2_1 and EL2_2. In this case, the bridge pattern BRP of each of the second electrodes EL2 may be a predetermined area of the first sub-electrode EL2_1 or a predetermined area of the second sub-electrode EL2_2.

In an embodiment of the present disclosure, the insulating pattern INSP may be provided and/or formed on the bridge pattern BRP of each of the second electrodes EL2. The bridge pattern BRP of each of the second electrodes EL2 may be electrically separated or insulated, by the insulating pattern INSP, from the 1-2-th connection line CNL1_2 that is provided and/or formed thereover.

The first and second sub-electrodes EL2_1 and EL2_2 of each of the second electrodes EL2 may be disposed in the first direction DR1 and electrically connected by the bridge pattern BRP. One end of the first sub-electrode EL2_1 of each of the second electrodes EL2 may be electrically connected to the intermediate electrode CTE, and the other end thereof may be electrically connected to a first side of the bridge pattern BRP. The second sub-electrode EL2_2 of each of the second electrodes EL2 may be electrically connected to a second side of the bridge pattern BRP.

In an embodiment of the present disclosure, the first and second sub-electrodes EL2_1 and EL2_2 of each of the second electrodes EL2 may have a rhombic shape, but the present disclosure is not limited thereto. In an embodiment, the shape thereof may be changed in various ways. Furthermore, each of the first and second sub-electrodes EL2_1 and EL2_2 of each of the second electrodes EL2 may have a shape identical with that of the first electrodes EL1, but the present disclosure is not limited thereto, and, in an embodiment, it may have a shape different from that of the first electrodes EL1. The first and second sub-electrodes EL2_1 and EL2_2 of each of the second electrodes EL2 may have a surface profile corresponding to the shape of the second partition wall PW2 disposed thereunder. Furthermore, the first and second sub-electrodes EL2_1 and EL2_2 of each of the second electrodes EL2 may have a surface area which is broad (or large) enough to completely cover the second partition wall PW2.

The intermediate electrode CTE, the bridge pattern BRP, the first and second sub-electrodes EL2_1 and EL2_2 of each of the second electrodes EL2 may be integral with each other and electrically and/or physically connected to each other. The second electrodes EL2 may be disposed at a position spaced apart from the first electrodes EL1 by a predetermined distance on an identical plane such that the second electrodes EL2 are electrically and/or physically separated from the first electrodes EL1. Although in the foregoing embodiment, the second electrodes EL2 and the first electrodes EL1 are illustrate as being disposed on an identical layer, the present disclosure is not limited thereto. In an embodiment, the second electrodes EL2 and the first electrodes EL1 may be disposed on different layers.

In an embodiment of the present disclosure, each of the first electrodes EL1 and the second electrodes EL2 may function as alignment electrodes for aligning the light emitting elements LD in the emission area EMA of each of the first to third pixels PXL1 to PXL3.

Before the light emitting elements LD are aligned in the emission area EMA of each of the first to third pixels PXL1 to PXL3, a first alignment voltage may be applied to each of the first electrodes EL1 through the first connection line CNL1, and a second alignment voltage may be applied to each of the second electrodes EL2 through the second connection line CNL2. The first alignment voltage and the second alignment voltage may have different voltage levels. For example, the first alignment voltage may be a ground voltage, and the second alignment voltage may be an alternating current voltage.

As predetermined alignment voltages having different voltage levels are respectively applied to each of the first electrodes EL1 and each of the second electrodes EL2, an electric field may be formed between the first electrodes EL1 and the second electrodes EL2. Hence, the light emitting elements LD may be aligned between the first electrodes EL1 and the second electrodes EL2 by the electric field.

After the light emitting elements LD are aligned in the emission area EMA of each of the first to third pixels PXL1 to PXL3, each of the first electrodes EL1 and the second electrodes EL2 may function as a driving electrode for driving the light emitting elements LD.

Each of the first electrodes EL1 and the second electrodes EL2 may be made of a material having a predetermined reflectivity to allow light emitted from the opposite ends EP1 and EP2 of each of the light emitting elements LD to travel in an image display direction (e.g., in a frontal direction) of the display device.

In an embodiment of the present disclosure, the first electrodes EL1, the second electrodes EL2, and the second connection line CNL2 may be provided on an identical layer and formed of an identical material.

The first electrodes EL1, the second electrodes EL2, and the second connection line CNL2 may be formed of a conductive material having a predetermined reflectivity. The conductive material may include metal such as Ag, Mg, Al, Pt, Pd, Au, Ni, Nd, Ir, Cr, Ti, or an alloy of them, a transparent conductive oxide such as an indium tin oxide (ITO), an indium zinc oxide (IZO), a zinc oxide (ZnO), or an indium tin zinc oxide (ITZO), and a conductive polymer such as PEDOT. In case that each of the first electrodes EL1, the second electrodes EL2, and the second connection line CNL2 includes a transparent oxide or a conductive polymer, a separate conductive layer made of opaque metal may be provided to reflect light emitted from the light emitting elements LD in the image display direction of the display device. The material of each of the first electrodes EL1, the second electrodes EL2, and the second connection line CNL2 is not limited to the foregoing materials.

Furthermore, although each of the first electrodes EL1, the second electrodes EL2, and the second connection line CNL2 is formed of a single layer, the present disclosure is not limited thereto. In an embodiment, the first electrodes EL1, the second electrodes EL2, and the second connection line CNL2 may be formed in a multi-layer structure formed by stacking two or more materials among metals, alloys, conductive oxides, and conductive polymers. Each of the first electrodes EL1, the second electrodes EL2, and the second connection line CNL2 may be formed of a multi-layer structure including at least two or more layers to minimize distortion resulting from a signal delay in case that signals (or voltages) are transmitted to opposite ends EP1 and EP2 of each of the light emitting elements LD. For example, each of the first electrodes EL1, the second electrodes EL2, and the second connection line CNL2 may be formed of a multi-layer structure in which layers are stacked in a sequence of ITO/Ag/ITO.

As described above, since each of the first electrodes EL1 and the second electrodes EL2 has a shape corresponding to the shape of the partition wall PW disposed therebelow, light emitted from the opposite ends EP1 and EP2 of each of the light emitting elements LD may be reflected by the first and second electrodes EL1 and EL2 and more effectively travel in the image display direction of the display device. Consequently, the efficiency of light emitted from each of the light emitting elements LD may be further enhanced.

In an embodiment of the present disclosure, the partition wall PW and the first and second electrodes EL1 and EL2 each may function as a reflective component configured to guide light emitted from the light emitting elements LD in a desired direction and thus enhance the light efficiency of the display device. In other words, the partition wall PW and the first and second electrodes EL1 and EL2 each may function as a reflective component configured to enable light emitted from the light emitting elements LD to travel in the image display direction of the display device, thereby enhancing the light output efficiency of the light emitting elements LD.

One of the first electrodes EL1 and the second electrodes EL2 may be an anode electrode, and the other electrode may be a cathode electrode. In an embodiment of the present disclosure, the first electrodes EL1 may be anode electrodes, and the second electrodes EL2 may be cathode electrodes.

In an embodiment of the present disclosure, the first connection line CNL1 may be provided and/or formed on a layer different from that of the first electrodes EL1, the second electrodes EL2, and the second connection line CNL2. In other words, the first connection line CNL1 may be formed by a process different from that of the first electrodes EL1, the second electrodes EL2, and the second connection line CNL2.

In an embodiment of the present disclosure, the first connection line CNL1 may be provided and/or formed on the insulating pattern INSP and be electrically insulated from the second electrodes EL2. Particularly, the 1-2-th connection line CNL1_2 of the first connection line CNL1 may be provided and/or formed on the insulating pattern INSP and electrically insulated from the second electrodes EL2. The 1-2-th connection line CNL1_2 may partially overlap the second electrodes EL2 with the insulating pattern INSP interposed therebetween. In detail, the 1-2-th connection line CNL1_2 may overlap the bridge pattern BRP of each of the second electrodes EL2 with the insulating pattern INSP interposed therebetween.

The insulating pattern INSP may be disposed between the bridge pattern BRP of each of the second electrodes EL2 and the 1-2-th connection line CNL1_2 and overlap each of the bridge pattern BRP and the 1-2-th connection line CNL1_2. The insulating pattern INSP may cover the bridge pattern BRP of each of the second electrodes EL2 and thus prevent the 1-2-th connection line CNL1_2 and the bridge pattern BRP from being electrically connected to each other. Hence, each of the first electrodes EL1 that is connected to the 1-2-th connection line CNL1_2 may be separated from each of the second electrodes EL2 rather than being electrically connected thereto.

In an embodiment of the present disclosure, the insulating pattern INSP may have a width W greater (or larger) than a lateral width of the 1-2-th connection line CNL1_2. Here, the lateral width of the 1-2-th connection line CNL1_2 may refer to a width of the 1-2-th connection line CNL1_2 that extends in the first direction DR1 in a plan view and a cross-sectional view. In a plan view, the insulating pattern INSP may have a rectangular shape corresponding to a shape of the bridge pattern BRP of each of the second electrodes EL2, but the present disclosure is not limited thereto. In an embodiment, the shape of the insulating pattern INSP may be changed in various ways within a range in which it has a width W greater (or larger) than the lateral width of the 1-2-th connection line CNL1_2 and sufficiently covers the bridge pattern BRP of each of the second electrodes EL2.

In an embodiment of the present disclosure, the insulating pattern INSP may be an inorganic insulating layer including an inorganic material. For example, the inorganic insulating layer may include at least one of silicon oxide (SiOₓ) and silicon nitride (SiNₓ).

Each of the light emitting elements LD may be formed of a light emitting diode which is made of a material having an inorganic crystal structure and has a subminiature size, e.g., a size corresponding to the nanometer scale or the micrometer scale. The light emitting elements LD may be aligned between the first electrode EL1 and the second electrode EL2 in each of the first to third pixels PXL1 to PXL3.

Although at least two to tens of light emitting elements LD are aligned in the emission area EMA of each of the first to third pixels PXL1 to PXL3, the present disclosure is not limited thereto. In an embodiment, the number of light emitting elements LD provided in each of the first to third pixels PXL1 to PXL3 may be changed in various ways.

Each of the light emitting elements LD may include a cylindrical light emitting element fabricated by an etching method, or a core-shell light emitting element fabricated by a growth scheme.

In case that each of the light emitting elements LD is a cylindrical light emitting element, each light emitting element LD may include an emission stack (or a stacked pattern) formed by successively stacking a first conductive semiconductor layer 11, an active layer 12, a second conductive semiconductor layer 13, and an electrode layer 15 in the longitudinal direction (L) of each light emitting element LD. In case that each of the light emitting elements LD is a core-shell light emitting element, each light emitting element LD may include an emission pattern 10 having a first conductive semiconductor layer 11 disposed in a central portion, an active layer 12 which encloses at least one side of the first conductive semiconductor layer 11, a second conductive semiconductor layer 13 which encloses at least one side of the active layer 12, and an electrode layer 15 which encloses at least one side of the second conductive semiconductor layer 13.

Each of the light emitting elements LD may include a first end EP1 and a second end EP2. One of the first conductive semiconductor layer 11 and the second conductive semiconductor layer 13 may be disposed in the first end EP1 of each of the light emitting elements LD, and the other of the first conductive semiconductor layer 11 and the second conductive semiconductor layer 13 may be disposed at the second end EP2 thereof. Each of the light emitting elements LD may emit color light or white light.

The light emitting elements LD may be aligned between at least one of the first electrodes EL1 and at least one of the second electrodes EL2 by an electric field formed between the first electrodes EL1 and the second electrodes EL2 in the emission area EMA of each of the first to third pixels PXL1 to PXL3.

In detail, after the electric field has been formed between the first electrodes EL1 and the second electrodes EL2 that are formed in the emission area EMA of each of the first to third pixels PXL1 to PXL3, light emitting elements LD may be input into the emission area EMA by spraying and/or applying a fluidic solvent mixed with the light emitting elements LD by an inkjet printing method or the like.

In case that the light emitting elements LD are input into the emission area EMA of each of the first to third pixels PXL1 to PXL3, self-alignment of the light emitting elements LD may be induced by the electric field formed between each of the first electrodes EL1 and each of the second electrodes EL2. Therefore, the light emitting elements LD may be aligned between at least one of the first electrodes EL1 and at least one of the second electrodes EL2. In other words, the light emitting elements LD may be aligned in various directions in a target area, e.g., in the emission area EMA of each of the first to third pixels PXL1 to PXL3.

As described above, if each of the first electrodes EL1 and the second electrodes EL2 has a rhombic shape, and the first electrodes EL1 and the second electrodes EL2 are alternately disposed in the second direction DR2, one of the first electrodes EL1 may be disposed between two adjacent second electrodes EL2 in the second direction DR2. Therefore, a first electrode EL1 may be enclosed by the first and second sub-electrodes EL2_1 and EL2_2 included in each of the two second electrodes EL2. In other words, a first electrode EL1 may be enclosed by four sub-electrodes. In this case, light emitting elements LD may be aligned in four directions around the first electrode EL1.

A first capping layer CPL1 may be provided and/or formed on each of the first electrodes EL1. The first capping layer CPL1 may prevent the first electrodes EL1 from being damaged by a defect or the like caused during a process of fabricating the display device, and may further enhance adhesive force between each of the first electrodes EL1 and the passivation layer PSV. The first capping layer CPL1 may be formed of a transparent conductive material such as indium zinc oxide (IZO) to minimize loss of light that is emitted from each of the light emitting elements LD and reflected by the first electrodes EL1 in the image display direction of the display device.

The first capping layer CPL1 and the first electrodes EL1 disposed thereunder may have an identical shape. For example, in case that each of the first electrodes EL1 has a rhombic shape, the first capping layer CPL1 may also have a rhombic shape. However, the present disclosure is not limited thereto. In an embodiment, the first capping layer CPL1 and the first electrode EL1 may have different shapes. The first capping layer CPL1 may have a surface area (or a size) greater (or larger) than each of the first electrodes EL1 to sufficiently cover each of the first electrodes EL1 that is disposed thereunder.

A second capping layer CPL2 may be provided and/or formed on the second electrodes EL2 and the second connection line CNL2. The second capping layer CPL2 may prevent the second electrodes EL2 and the second connection line CNL2 from being damaged by a defect or the like caused during a process of fabricating the display device, and may further enhance adhesive force between the passivation layer PSV and each of the second electrodes EL2 and the second connection line CNL2.

As described above, since each of the second electrodes EL2 includes the intermediate electrode CTE, the first and second sub-electrodes EL2_1 and EL2_2, and the bridge pattern BRP, the second capping layer CPL2 may have a surface area (or a size) greater (or larger) than that of each of the second electrodes EL2 to cover all of the intermediate electrode CTE, the first and second sub-electrodes EL2_1 and EL2_2, and the bridge pattern BRP of each of the second electrodes EL2. Furthermore, the second capping layer CPL2 may have a surface area (or a size) greater (or larger) than that of each of the 2-1-th and 2-2-th connection lines CNL2_1 and CNL2_2 of the second connection line CNL2 to cover the 2-1-th and 2-2-th connection lines CNL2_1 and CNL2_2.

In an embodiment of the present disclosure, the second capping layer CPL2 may be provided on a layer identical to that of the first capping layer CPL1 and formed of material identical with that of the first capping layer CPL1. In other words, the second capping layer CPL2 may be provided through a process identical to that of the first capping layer CPL1. In an embodiment of the present disclosure, the first capping layer CPL1 and the second capping layer CPL2 may be disposed on an identical plane at positions spaced apart from each other. Hence, the first capping layer CPL1 and the second capping layer CPL2 may be electrically and/or physically separated from each other.

A third capping layer CPL3 may be provided and/or formed on the first connection line CNL1. The third capping layer CPL3 may prevent the first connection line CNL1 from being damaged by a defect or the like caused during a process of fabricating the display device, and may further enhance adhesive force between each of the first connection line CNL1 and the passivation layer PSV.

In an embodiment of the present disclosure, the third capping layer CPL3 may have a shape corresponding to that of the first connection line CNL1 and have a surface area (or size) greater (or larger) than that of each of the 1-1-th and 1-2-th connection lines CNL1_1 and CNL1_2 of the first connection line CNL1 to cover the 1-1-th and 1-2-th connection lines CNL1_1 and CNL1_2. The third capping layer CPL3 may be formed of a transparent conductive material such as indium zinc oxide (IZO) to minimize loss of light emitted from the light emitting elements LD, in the same manner as that of the first and second capping layers CPL1 and CPL2.

In an embodiment of the present disclosure, the third capping layer CPL3 and the first and second capping layers CPL1 and CPL2 may be provided and/or formed on a layer different from that of the first and second capping layers CPL1 and CPL2. Hence, the third capping layer CPL3 may be electrically and/or physically separated from each of the first and second capping layers CPL1 and CPL2.

The light emitting elements LD may be aligned between at least one of the first electrodes EL1 and at least one of the second electrodes EL2 in the emission area EMA of each of the first to third pixels PXL1 to PXL3. Particularly, one of the opposite ends EP1 and EP2 of the light emitting elements LD may be electrically connected to at least one first electrode EL1, and the other of the opposite ends EP1 and EP2 of the light emitting elements LD may be electrically connected to at least one second electrode EL2. Hence, a signal (or a voltage) of the first transistor T1 (T) of the pixel circuit layer PCL of each of the first to third pixels PXL1 to PXL3 may be applied to one of the opposite ends EP1 and EP2 of the light emitting elements LD via at least one first electrode EL1. The voltage of the second driving power supply VSS of the driving voltage line DVL may be applied to the other end of the opposite ends EP1 and EP2 of the light emitting elements LD via at least one second electrode EL2.

The light emitting elements LD may form a valid light source of each of the first to third pixels PXL1 to PXL3. For example, if driving current flows through each of the first to third pixels PXL1 to PXL3 during each frame period, the light emitting elements LD electrically connected to the first and second electrodes EL1 and EL2 of the corresponding pixel PXL may emit light having a luminance corresponding to the driving current.

The above-mentioned light emitting elements LD may be aligned on a first insulating layer INS1 in the emission area EMA of each of the first to third pixels PXL1 to PXL3.

The first insulating layer INS1 may be formed and/or provided under each of the light emitting elements LD that are aligned between at least one of the first electrodes EL1 and at least one of the second electrodes EL2 in the emission area EMA of each of the first to third pixels PXL1 to PXL3. The first insulating layer INS1 may be charged into a space between the passivation layer PSV and each of the light emitting elements LD to stably support the light emitting elements LD and prevent the light emitting elements LD from being removed from the passivation layer PSV.

In the emission area EMA of each of the first to third pixels PXL1 to PXL3, the first insulating layer INS1 may expose a predetermined area of each of the first electrodes EL1 and cover a remaining area other than the exposed predetermined area to protect the remaining area of each of the first electrodes EL1. Furthermore, the first insulating layer INS1 may expose a predetermined area of the second electrodes EL2 and cover a remaining area other than the exposed predetermined area to protect the remaining area of the second electrodes EL2. In addition, the first insulating layer INS1 may be formed and/or provided on the passivation layer PSV in the peripheral area of each of the first to third pixels PXL1 to PXL3 to protect components disposed in the peripheral area.

The first insulating layer INS1 may be formed of an inorganic insulating layer including an inorganic material, or an organic insulating layer including organic material. Although in an embodiment of the present disclosure the first insulating layer INS1 may be formed of an inorganic insulating layer having an advantage in protecting the light emitting elements LD from the pixel circuit layer PCL of each of the first to third pixels PXL1 to PXL3, the present disclosure is not limited thereto. In an embodiment, the first insulating layer INS1 may be formed of an organic insulating layer that has an advantage in planarization of support surfaces of the light emitting elements LD.

As shown in the foregoing embodiment, in case that the first capping layer CPL1 is provided on each of the first electrodes EL1 and the second capping layer CPL2 is provided on each of the second electrodes EL2, the first insulating layer INS1 may expose a predetermined area of each of the first and second capping layers CPL1 and CPL2 and cover a remaining area other than the exposed predetermined area to protect the remaining area of each of the first and second capping layers CPL1 and CPL2. In addition, the first insulating layer INS1 may cover the first and second connection lines CNL1 and CNL2 in the peripheral area of each of the first to third pixels PXL1 to PXL3 to protect the first and second connection lines CNL1 and CNL2.

A second insulating layer INS2 may be provided and/or formed on the light emitting elements LD. The second insulating layer INS2 may be provided and/or formed on each of the light emitting elements LD to cover a portion of an upper surface of each of the light emitting elements LD, and expose the opposite ends EP1 and EP2 of each of the light emitting elements LD to the outside. The second insulating layer INS2 may be formed in an independent pattern in the emission area EMA of each of the first to third pixels PXL1 to PXL3, but the present disclosure is not limited thereto.

The second insulating layer INS2 may be formed of a single layer or multiple layers and include an inorganic insulating layer including at least one inorganic material or an organic insulating layer including at least one organic material. The second insulating layer INS2 may affix in place each of the light emitting elements LD aligned in the emission area EMA of each of the first to third pixels PXL1 to PXL3. In an embodiment of the present disclosure, the second insulating layer INS2 may include an inorganic insulating layer that has an advantage in protecting the active layer 12 of each of the light emitting elements LD from external oxygen, water, etc. However, the present disclosure is not limited thereto. The second insulating layer INS2 may be formed of an organic insulating layer including an organic material, depending on design conditions of the display device to which the light emitting elements LD are applied.

In an embodiment of the present disclosure, after the alignment of the light emitting elements LD in the emission area EMA of each of the first to third pixels PXL1 to PXL3 has been completed, the second insulating layer INS2 is formed on the light emitting elements LD so that the light emitting elements LD may be prevented from being removed from the aligned positions. If space is present between the first insulating layer INS1 and the light emitting elements LD before the second insulating layer INS2 is formed, the space may be filled with the second insulating layer INS2 during a process of forming the second insulating layer INS2. Consequently, the light emitting elements LD may be stably supported. Hence, the second insulating layer INS2 may be formed of an organic insulating layer that has an advantage in filling the space between the first insulating layer INS1 and the light emitting elements LD with the second insulating layer INS2.

In an embodiment of the present disclosure, the second insulating layer INS2 may be formed on each of the light emitting elements LD so that the active layer 12 of each of the light emitting elements LD may be prevented from contacting an external conductive material. The second insulating layer INS2 may cover only a portion of the surface of each of the light emitting elements LD such that the opposite ends EP1 and EP2 of each of the light emitting elements LD may be exposed to the outside.

The first contact electrode CNE1 may be provided and/or formed on the first electrodes EL1 of each of the first to third pixels PXL1 to PXL3 to electrically and/or physically reliably connect the first electrodes EL1 with one of the opposite ends EP1 and EP2 of each of the light emitting elements LD. The second contact electrode CNE2 may be provided and/or formed on the second electrodes EL2 of each of the first to third pixels PXL1 to PXL3 to electrically and/or physically reliably connect the second electrodes EL2 with the other of the opposite ends EP1 and EP2 of each of the light emitting elements LD.

In an embodiment, each of the first and second contact electrodes CNE1 and CNE2 may be formed of various transparent conductive materials. For example, each of the first and second contact electrodes CNE1 and CNE2 may be formed of a transparent conductive material for minimizing loss of light that is emitted from each of the light emitting elements LD and reflected in the frontal direction of the display device by the corresponding electrode. The transparent conductive material may include at least one of various conductive materials, e.g., ITO, IZO, and ITZO, and may be substantially transparent or semi-transparent to satisfy a predetermined transmittancy. The material of the first and second contact electrodes CNE1 and CNE2 is not limited to the above-mentioned materials.

Each of the first and second contact electrodes CNE1 and CNE2 may have a bar shape extending in the second direction DR2. The first contact electrode CNE1 may partially overlap one of the opposite ends EP1 and EP2 of each of the light emitting elements LD. The second contact electrode CNE2 may partially overlap the other of the opposite ends EP1 and EP2 of each of the light emitting elements LD.

In an embodiment of the present disclosure, the first and second contact electrodes CNE1 and CNE2 may be provided on respective different layers. In this case, the first contact electrode CNE1 may be provided and/or formed on the second insulating layer INS2 and covered with a third insulating layer INS3. Furthermore, the second contact electrode CNE2 may be provided and/or formed on the third insulating layer INS3 and covered with a fourth insulating layer INS4. The third and fourth insulating layers INS3 and INS4 may be formed of any of an inorganic insulating layer including an inorganic material or an organic insulating layer including an organic material. An overcoat layer OC may be provided and/or formed on the fourth insulating layer INS4.

In an embodiment of the present disclosure, the first contact electrode CNE1 may be provided and/or formed not only on the first electrodes EL1 but also on the 1-2-th connection line CNL1_2 and thus electrically connected with the 1-2-th connection line CNL1_2. In a plan view, the first contact electrode CNE1 may overlap each of the first electrodes EL1, the 1-2-th connection line CNL1_2, the bridge pattern BRP of each of the second electrodes EL2, and the insulating pattern INSP.

In the first part A of the 1-2-th connection line CNL1_2, the first insulating layer INS1 may be disposed under the first contact electrode CNE1, the third capping layer CPL3 may be disposed under the first insulating layer INS1, the 1-2-th connection line CNL1_2 may be disposed under the third capping layer CPL3, the insulating pattern INSP may be disposed under the 1-2-th connection line CNL1_2, the second capping layer CPL2 may be disposed under the insulating pattern INSP, and the bridge pattern BRP of each of the second electrodes EL2 may be disposed under the second capping layer CPL2. In the first part A of the 1-2-th connection line CNL1_2, the first contact electrode CNE1 may be electrically separated from the third capping layer CPL3 and the 1-2-th connection line CNL1_2. Furthermore, in the first part A of the 1-2-th connection line CNL1_2, the first contact electrode CNE1 may be electrically separated from the second capping layer CPL2 and the bridge pattern BRP of each of the second electrodes EL2 by the insulating pattern INSP.

In the second part B of the 1-2-th connection line CNL1_2, the third capping layer CPL3 may be disposed under the first contact electrode CNE1, the 1-2-th connection line CNL1_2 may be disposed under the third capping layer CPL3, the first capping layer CPL1 may be disposed under the 1-2-th connection line CNL1_2, the first electrodes EL1 each may be disposed under the first capping layer CPL1, and the first partition wall PW1 may be disposed under each of the first electrodes EL1. Hence, in the second part B of the 1-2-th connection line CNL1_2, the first contact electrode CNE1, the third capping layer CPL3, the first capping layer CPL1, the 1-2-th connection line CNL1_2, and the first electrodes EL1 may be electrically and/or physically connected to each other.

In an embodiment of the present disclosure, the second contact electrode CNE2 may include a 2-1-th contact electrode CNE2_1 and a 2-2-th contact electrode CNE2_2.

The 2-1-th contact electrode CNE2_1 may be provided and/or formed on the first sub-electrode EL2_1 of each of the second electrodes EL2 and thus electrically connected to the first sub-electrode EL2_1. The 2-2-th contact electrode CNE2_2 may be provided and/or formed on the second sub-electrode EL2_2 of each of the second electrodes EL2 and thus electrically connected to the second sub-electrode EL2_2.

In a plan view, the 2-1-th contact electrode CNE2_1 may overlap the first sub-electrode EL2_1 of each of the second electrodes EL2 and one of the opposite ends EP1 and EP2 of each of the light emitting elements LD. The 2-1-th contact electrode CNE2_1 may electrically connect the first sub-electrode EL2_1 of each of the second electrodes EL2 with one of the opposite ends EP1 and EP2 of each of the light emitting elements LD.

In a plan view, the 2-2-th contact electrode CNE2_2 may overlap the second sub-electrode EL2_2 of each of the second electrodes EL2 and one of the opposite ends EP1 and EP2 of each of the light emitting elements LD. The 2-2-th contact electrode CNE2_2 may electrically connect the second sub-electrode EL2_2 of each of the second electrodes EL2 with one of the opposite ends EP1 and EP2 of each of the light emitting elements LD.

Although in the foregoing embodiment the first and second contact electrodes CNE1 and CNE2 are illustrated as being provided and/or formed on respective different layers, the present disclosure is not limited thereto. In an embodiment, the first and second contact electrodes CNE1 and CNE2 may be provided and/or formed on an identical layer, as illustrated in FIG. 8. In this case, the first contact electrode CNE1 and the second contact electrode CNE2 may be spaced apart from each other by a predetermined distance on the second insulating layer INS2 and thus electrically separated from each other, and may be covered with the third insulating layer INS3. The overcoat layer OC may be provided and/or formed on the third insulating layer INS3. Here, the third insulating layer INS3 may correspond to the fourth insulating layer INS4 in case that the first and second contact electrodes CNE1 and CNE2 are provided and/or formed on the same layer.

The overcoat layer OC may be an encapsulation layer configured to mitigate a step difference formed by the partition wall PW, the first and second contact electrodes CNE1 and CNE2, and the first and second electrodes EL1 and EL2 that are disposed under the overcoat layer OC, and prevent oxygen or water from permeating the light emitting elements LD. In an embodiment, the overcoat layer OC may be omitted in consideration of design conditions, etc. of the display device.

As described above, predetermined voltages are applied to the opposite ends EP1 and EP2 of each of the light emitting elements LD through the first electrodes EL1 and the second electrodes EL2 so that each of the light emitting elements LD may emit light by recombination of electron-hole pairs in the active layer 12 of each light emitting element LD. Each of the light emitting elements LD may emit light having a wavelength band, e.g., ranging from 400 nm to 900 nm.

In an embodiment of the present disclosure, first electrodes EL1 and second electrodes EL2 that are disposed in the emission area EMA of each of the first to third pixels PXL1 to PXL3 may be alternately disposed in the second direction DR2 rather than being disposed in an identical row. In this case, one of the first electrodes EL1 may be disposed between two adjacent second electrodes EL2 in the second direction DR2. In other words, a first electrode EL1 may be enclosed by four sub-electrodes in diagonal directions of the first electrode EL1.

Here, in case that one first electrode EL1 and four sub-electrodes that enclose the first electrode EL1 have a rhombic shape, a sub-electrode may correspond to one of four sides of the first electrode EL1. For example, based on a first electrode EL1 (hereinafter referred to as "1-3-th electrode") disposed in a third row in the emission area EMA of the first pixel PXL1, the first sub-electrode EL2_1 of the second electrode EL2 (hereinafter referred to as "2-1-th electrode") that is disposed at an upper side of the 1-3-th electrode EL1 may correspond to a first side S1 of the 1-3-th electrode EL1, and the second sub-electrode EL2_2 of the 2-1-th electrode EL2 may correspond to a second side S2 of the 1-3-th electrode EL1. Furthermore, the first sub-electrode EL2_1 of the second electrode EL2 (hereinafter referred to as "2-2-th electrode") that is disposed at a lower side of the 1-3-th electrode EL1 may correspond to a third side S3 of the 1-3-th electrode EL1, and the second sub-electrode EL2_2 of the 2-2-th electrode EL2 may correspond to a fourth side S4 of the 1-3-th electrode EL1.

If the 1-3-th electrode EL1, the 2-1-th electrode EL2, and the 2-2-th electrode EL2 are supplied with respective corresponding alignment voltages to align the light emitting elements LD, electric fields may be respectively formed between the 1-3-th electrode EL1 and the 2-1-th electrode EL2 and between the 1-3-th electrode EL1 and the 2-2-th electrode EL2. A direction of an electric field formed between the first side S1 of the 1-3-th electrode EL1 and the first sub-electrode EL2_1 of the 2-1-th electrode EL2 may differ from a direction of an electric field formed between the second side S2 of the 1-3-th electrode EL1 and the second sub-electrode EL2_2 of the 2-1-th electrode EL2. Furthermore, a direction of an electric field formed between the third side S3 of the 1-3-th electrode EL1 and the first sub-electrode EL2_1 of the 2-2-th electrode EL2 may differ from a direction of an electric field formed between the fourth side S4 of the 1-3-th electrode EL1 and the second sub-electrode EL2_2 of the 2-2-th electrode EL2. Here, in case that, to align light emitting elements LD, the light emitting elements LD are input into the emission area EMA of the first pixel PXL1, the light emitting elements LD may be aligned in various directions depending on directions of the electric fields that are respectively formed between the 1-3-th electrode EL1 and the 2-1-th electrode EL2 and between the 1-3-th electrode EL1 and the 2-2-th electrode EL2.

As a result, in case that the respective first electrodes EL1 and the respective second electrodes EL2 are alternately disposed in the second direction DR2 in the emission area EMA of each of the first to third pixels PXL1 to PXL3 and each of the first and second electrodes EL1 and EL2 has a rhombic shape, the light emitting elements LD aligned in the emission area EMA of the corresponding pixel PXL may be prevented from being biased in a specific direction, e.g., in the first direction DR1 and/or the second direction DR2. Therefore, light emitted from each of the light emitting elements LD may be prevented from being concentrated in a specific direction. Hence, the display device in an embodiment of the present disclosure may have uniform light output distribution on the overall area thereof.

If each of the first and second electrodes EL1 and EL2 has a bar shape extending in the second direction DR2 in the same manner as that of the conventional display device, an electric filed having a predetermined orientation is formed between the first and second electrodes EL1 and EL2 in case that alignment voltages are respectively applied to the first and second electrodes EL1 and EL2. In this case, the light emitting elements LD are aligned in an identical direction, e.g., the first direction DR1, in the emission area EMA of each of the first to third pixels PXL1 to PXL3, and light emitted from each of the light emitting elements LD may intensively travel in the first direction DR1. In other words, depending on the alignment direction of the light emitting elements LD, light emitted from each of the light emitting elements LD may be concentrated. In case that light is concentrated in a specific direction in the emission area EMA of each of the first to third pixels PXL1 to PXL3, light output distribution may vary by areas of the display device, thereby causing an image quality defect.

Accordingly, in the display device in accordance with an embodiment of the present disclosure, the first electrodes EL1 and the second electrodes EL2 may be alternately disposed in the second direction DR2 in the emission area EMA of each of the first to third pixels PXL1 to PXL3 rather than being disposed in an identical direction so that the light emitting elements LD are aligned in various directions to prevent light emitted from each of the light emitting elements LD from being concentrated in a specific direction.

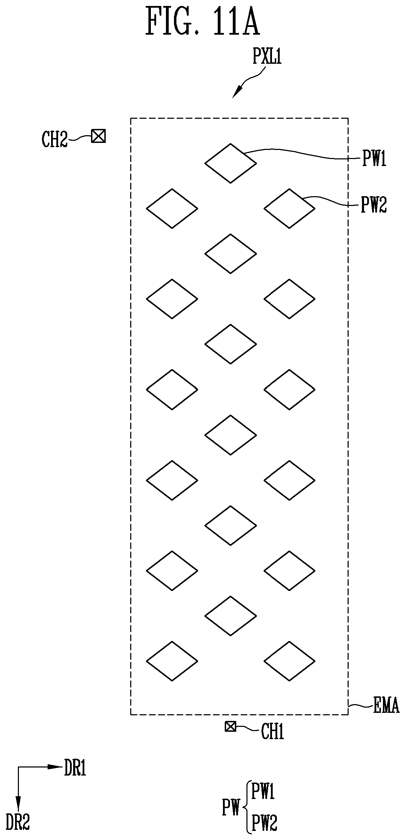

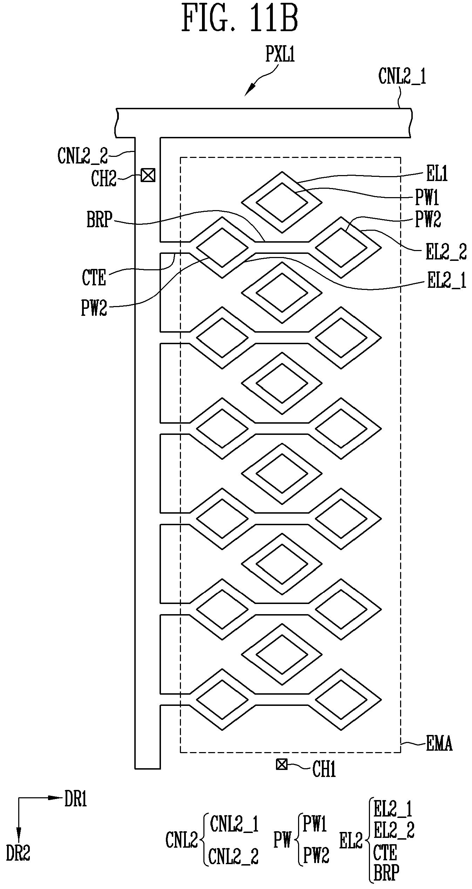

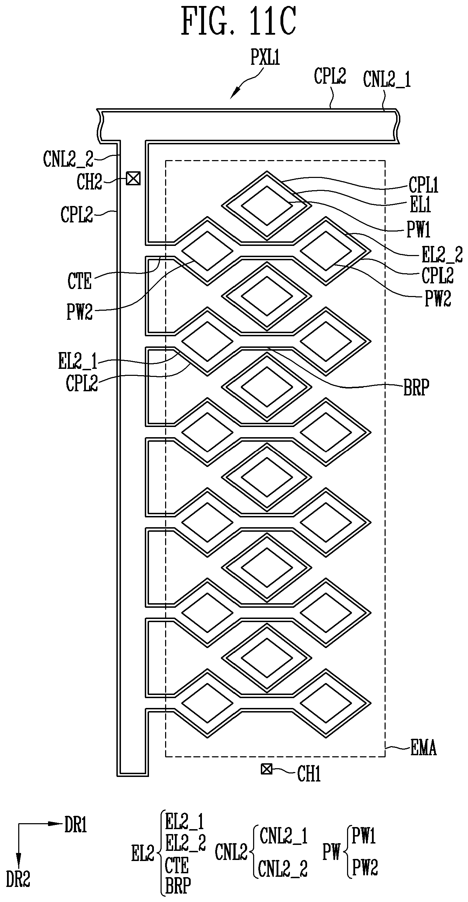

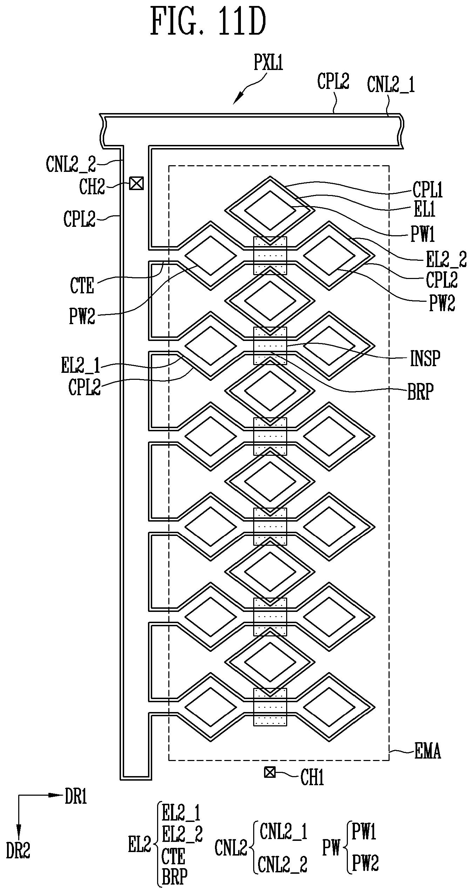

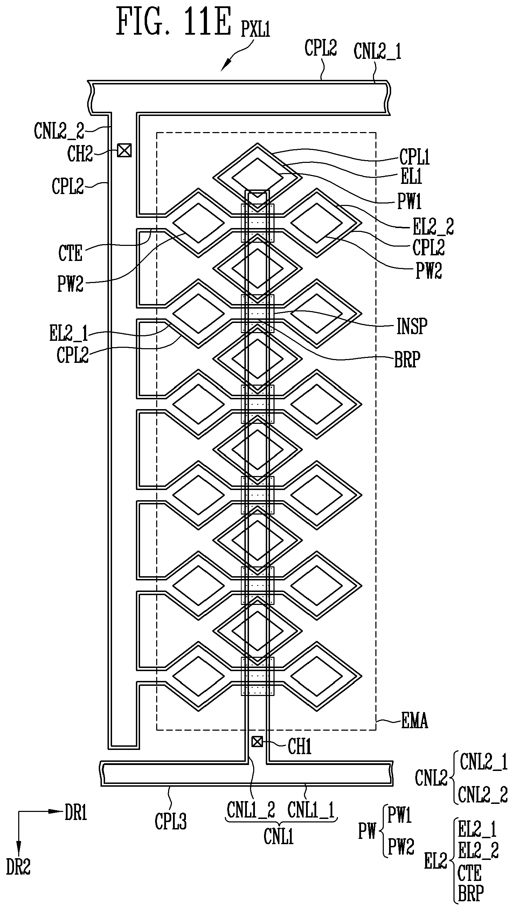

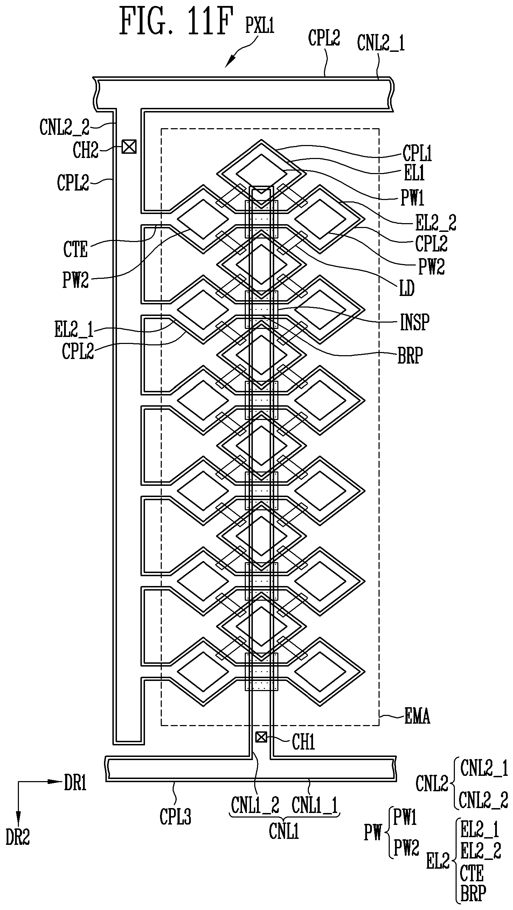

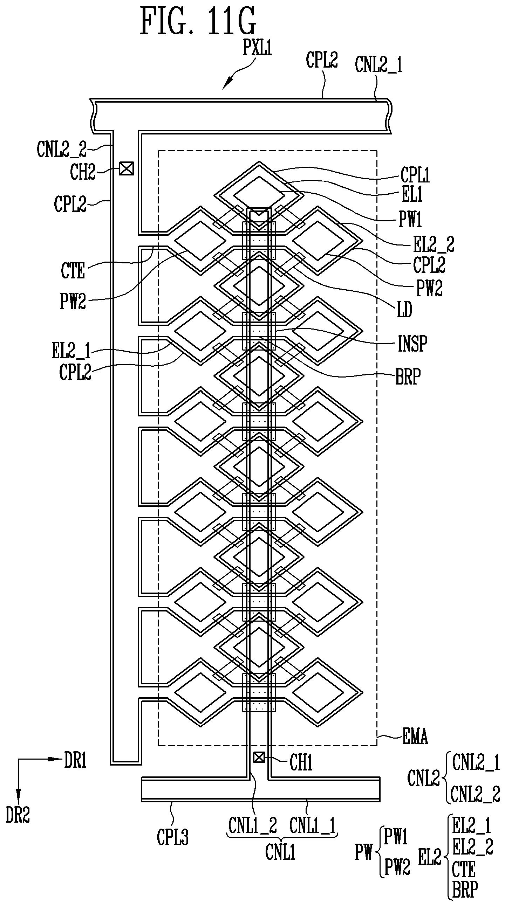

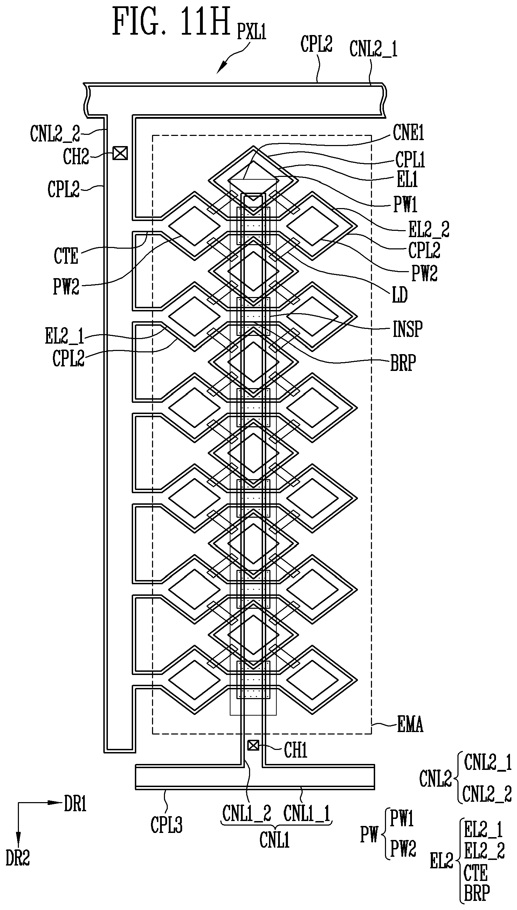

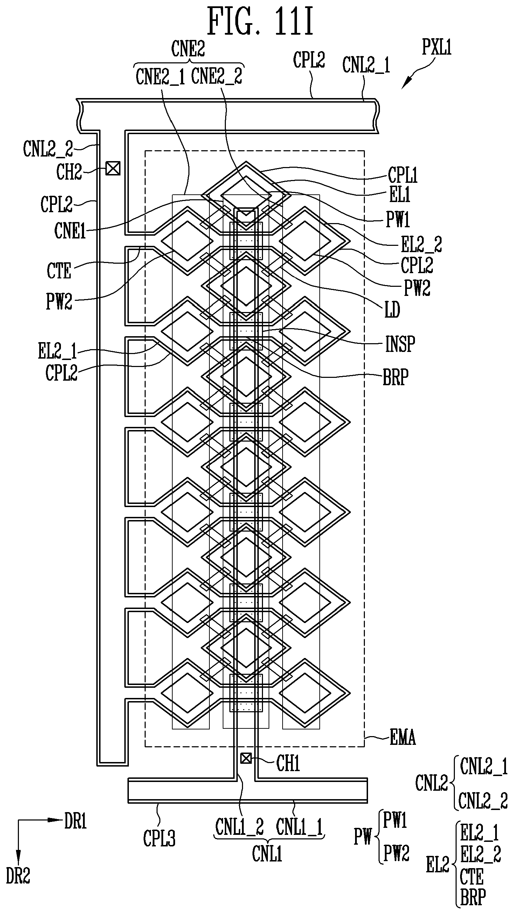

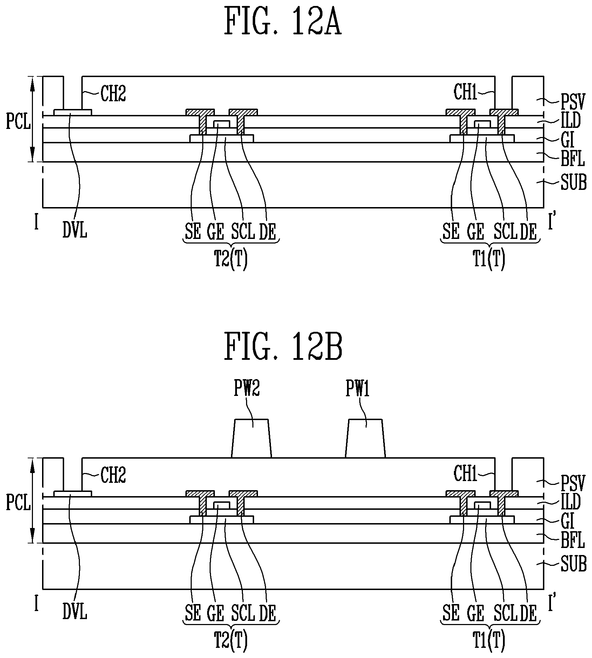

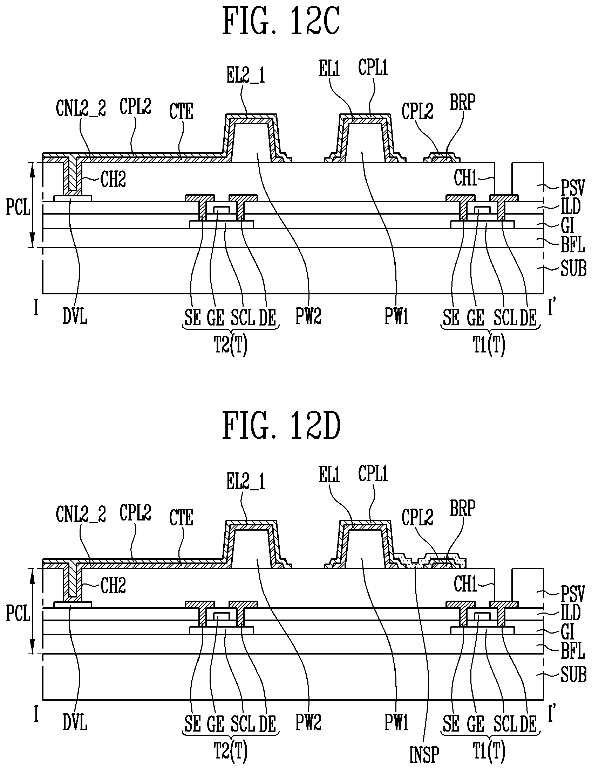

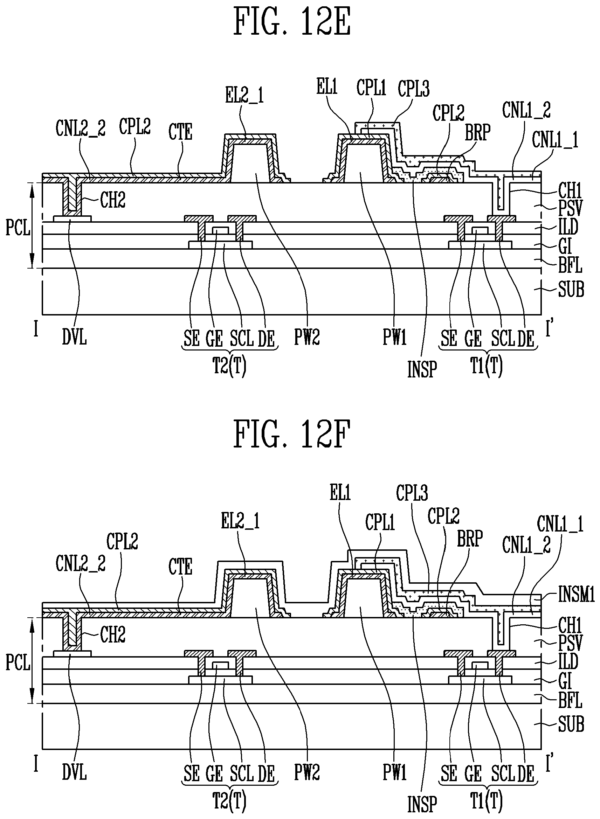

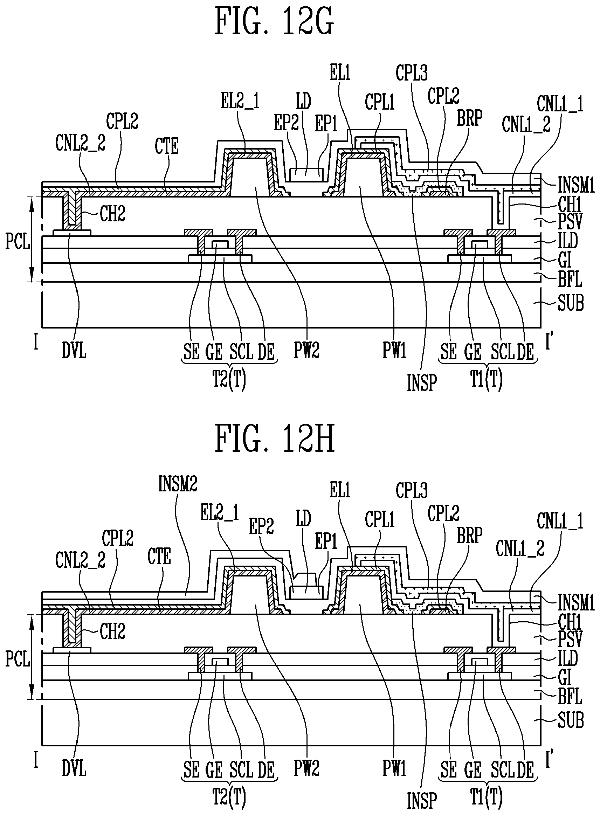

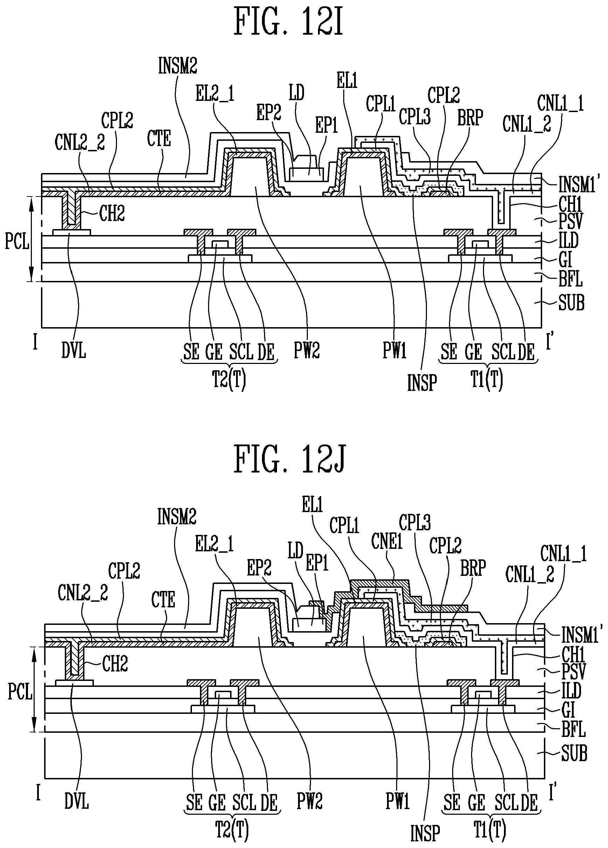

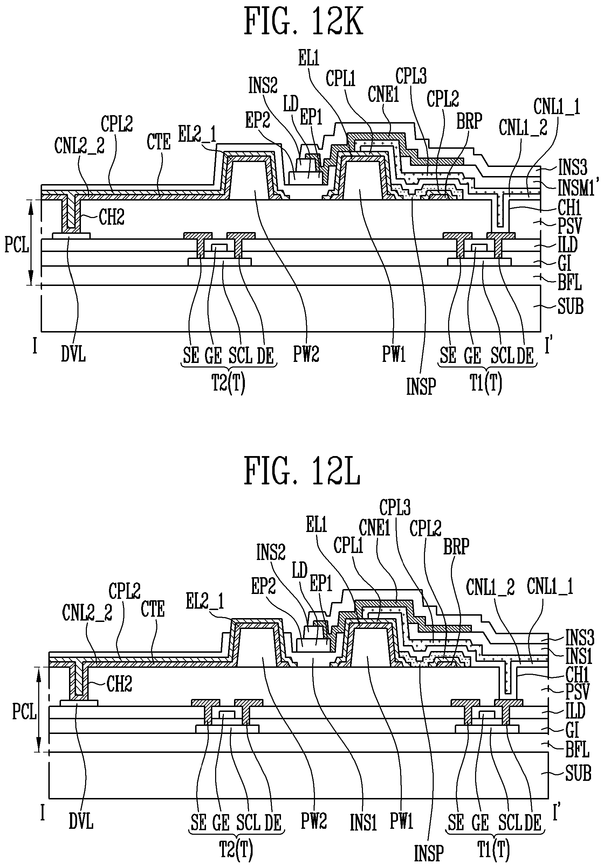

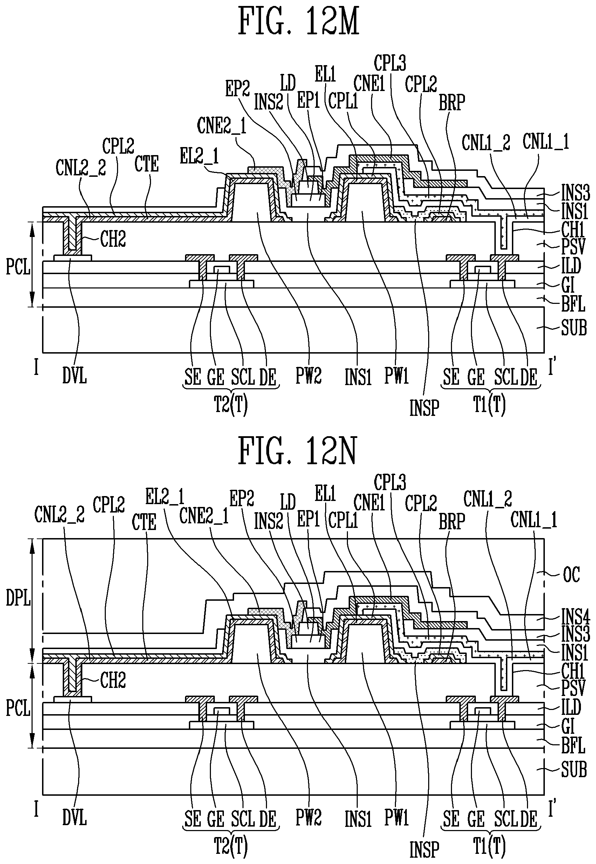

FIGS. 11a to 11i are schematic plan views sequentially illustrating a method of fabricating the first pixel illustrated in FIG. 4. FIGS. 12a to 12n are schematic cross-sectional views sequentially illustrating a method of fabricating the first pixel illustrated in FIG. 6.

Referring to FIGS. 1a to 1f, 2, 3a, 4, 6, and 12a, the pixel circuit layer PCL of the first pixel PXL1 is formed on the substrate SUB. The first pixel PXL1 may include an emission area EMA, and a peripheral area disposed around the emission area EMA.

The pixel circuit layer PCL may include the first transistor T1 (T), the second transistor T2 (T), the driving voltage line DVL, and the passivation layer PSV. The passivation layer PSV may include a first contact hole CH1 which exposes a second terminal DE of the first transistor T1 (T), and a second contact hole CH2 which exposes a portion of the driving voltage line DVL.

Referring to FIGS. 1a to 1f, 2, 3a, 4, 6, 11a, 12a, and 12b, the first and second partition walls PW1 and PW2 are formed on the passivation layer PSV in the emission area EMA of the first pixel PXL1. The first partition wall PW1 and the second partition wall PW2 may be spaced apart from each other by a predetermined distance on the passivation layer PSV. The first and second partition walls PW1 and PW2 may be formed of an inorganic insulating layer including inorganic material, or an organic insulating layer including organic material.

Referring to FIGS. 1a to 1f, 2, 3a, 4, 6, 11b, 11c, and 12a to 12c, the first electrodes EL1, the second electrodes EL2, and the second connection line CNL2 are formed on the passivation layer PSV including the first and second partition walls PW1 and PW2.

Each of the first electrodes EL1 may be spaced apart from an adjacent first electrode EL1 by a predetermined distance in the second direction DR2. Furthermore, each of the first electrodes EL1 may be spaced apart from each of the second connection line CNL2 and the second electrodes EL2 by a predetermined distance. In an embodiment of the present disclosure, one of the first electrodes EL1 may be disposed between two adjacent second electrodes EL2 in the second direction DR2.

In a plan view, the first and second sub-electrodes EL2_1 and EL2_2 of each of the second electrodes EL2 and each of the first electrodes EL1 may have a rhombus shape. Hence, each of the first and second sub-electrodes EL2_1 and EL2_2 of each of the second electrodes EL2 and each of the first electrodes EL1 may have four sides.

The second connection line CNL2 may include a 2-1-th connection line CNL2_1 extending in the first direction DR1, and a 2-2-th connection line CNL2_2 extending in the second direction DR2 intersecting the first direction DR1.

Each of the second electrodes EL2 may include an intermediate electrode CTE electrically connected to the 2-2-th connection line CNL2_2, a first sub-electrode EL2_1 electrically connected to the intermediate electrode CTE, a bridge pattern BRP electrically connected to the first sub-electrode EL2_1, and a second sub-electrode EL2_2 electrically connected to the bridge pattern BRP. The bridge pattern BRP of each of the second electrodes EL2 may be provided between the first and second sub-electrodes EL2_1 and EL2_2 of each of the second electrodes EL2.

The second partition wall PW2 may be disposed under each of the first and second sub-electrodes EL2_1 and EL2_2. The first partition wall PW1 may be disposed under each of the first electrodes EL1. In a plan view, each of the first electrodes EL1 may overlap the first partition wall PW1. Each of the first and second sub-electrodes EL2_1 and EL2_2 may overlap the second partition wall PW2.

Subsequently, the first capping layer CPL1 is formed on the first electrodes EL1, and the second capping layer CPL2 is formed on each of the second electrodes EL2 and the second connection line CNL2. In an embodiment of the present disclosure, the first capping layer CPL1 and the second capping layer CPL2 may include an identical material and be formed by an identical process.

The first capping layer CPL1 may cover each of the first electrodes EL1 and overlap each of the first electrodes EL1 in a plan view. The second capping layer CPL2 may cover all of the second electrodes EL2 and the second connection line CNL2 and overlap each of the second electrodes EL2 and the second connection line CNL2, in a plan view.

Referring to FIGS. 1a to 1f, 2, 3a, 4, 6, 11d, and 12a to 12d, after an insulating material layer (not illustrated) is applied onto the passivation layer PSV on which the first and second capping layers CPL1 and CPL2 are formed, the insulating pattern INSP that covers only the bridge pattern BRP of each of the second electrodes EL2 and the second capping layer CPL2 disposed on the bridge pattern BRP is formed by patterning the insulating material layer by a mask process.

The insulating pattern INSP may be an inorganic insulating layer including an inorganic material.

Referring to FIGS. 1a to 1f, 2, 3a, 4, 6, 11e, and 12a to 12e, the first connection line CNL1 is formed on the passivation layer PSV on which the insulating pattern INSP is formed. The first connection line CNL1 may include a 1-1-th connection line CNL1_1 extending in the first direction DR1, and a 1-2-th connection line CNL1_2 extending in the second direction DR2.

The 1-2-th connection line CNL1_2 may extend in the second direction DR2 and cover the first electrodes EL1 disposed in an identical column, and may be electrically connected with each of the first electrodes EL1. In detail, the 1-2-th connection line CNL1_2 may be provided and/or formed on the bridge pattern BRP of each of the second electrodes EL2 with the insulating pattern INSP interposed therebetween. The bridge pattern BRP of each of the second electrodes EL2 may be covered with the insulating pattern INSP and be electrically separated from the 1-2-th connection line CNL1_2. In other words, the bridge pattern BRP of each of the second electrodes EL2 may remain electrically insulated from the 1-2-th connection line CNL1_2 by the insulating pattern INSP.

The 1-2-th connection line CNL1_2 may be electrically connected to the second terminal DE of the first transistor T1 (T) through the first contact hole CH1 of the passivation layer PSV.

Subsequently, the third capping layer CPL3 is formed on the first connection line CNL1.

The third capping layer CPL3 may be formed of a transparent conductive material and be formed directly on the first connection line CNL1 and electrically and/or physically connected with the first connection line CNL1. The third capping layer CPL3 and the first and second capping layers CPL1 and CPL2 may include an identical material.

Referring to FIGS. 1a to 1f, 2, 3a, 4, 6, and 12a to 12f, a first insulating material layer INSM1 is formed on the passivation layer PSV on which the third capping layer CPL3 is formed. The first insulating material layer INSM1 may be formed of an inorganic insulating layer including inorganic material, or an organic insulating layer including an organic material.

Referring to FIGS. 1a to 1f, 2, 3a, 4, 6, 11f, and 12a to 12g, an electric field is formed between each of the first electrodes EL1 and each of the second electrodes EL2 by respectively applying corresponding alignment voltages to the first electrodes EL1 and the second electrodes EL2 through the first connection line CNL1 and the second connection line CNL2.

In case that direct current power or alternating current power having a predetermined voltage and period is repeatedly applied several times to each of the first and second electrodes EL1 and EL2 through the first and second connection lines CNL1 and CNL2, an electric field may be formed between the first and second electrodes EL1 and EL2 by a difference in potential between the first and second electrodes EL1 and EL2.

After the electric field is formed between the first electrodes EL1 and the second electrodes EL2 that are formed in the emission area EMA of the first pixel PXL1, light emitting elements LD are supplied in an inkjet printing method or the like. For example, the light emitting elements LD may be supplied to the emission area EMA of the first pixel PXL1 by disposing a nozzle over the passivation layer PSV and dropping a solvent including the light emitting elements LD onto the passivation layer PSV through the nozzle. Here, the solvent may be any of acetone, water, alcohol, and toluene, but the present disclosure is not limited thereto. For example, the solvent may include a material which may be vaporized at room temperature or by heat. Furthermore, the solvent may have the form of ink or paste. The method of supplying the light emitting elements LD is not limited to that of the foregoing embodiment. The method of supplying the light emitting elements LD may be changed in various ways.

After the light emitting elements LD are supplied to the emission area EMA of the first pixel PXL1, the solvent may be removed.

In case that the light emitting elements LD are input into the emission area EMA of the first pixel PXL1, self-alignment of the light emitting elements LD may be induced by the electric field formed between the first electrodes EL1 and the second electrodes EL2. Therefore, the light emitting elements LD may be aligned between at least one of the first electrodes EL1 and at least one of the second electrodes EL2. In other words, the light emitting elements LD may be aligned in various directions in a target area, e.g., the emission area EMA of the first pixel PXL1. Particularly, each of the light emitting elements LD may be aligned on the first insulating material layer INSM1 in the emission area EMA of the first pixel PXL1.

Referring to FIGS. 1a to 1f, 2, 3a, 4, 6, 11g, and 12a to 12h, after the light emitting elements LD are aligned in the emission area EMA of the first pixel PXL1, the 1-1-th connection line CNL1_1 is divided into parts between the first pixel PXL1 and pixels PXL adjacent to the first pixel PXL1 so that the first pixel PXL1 can be driven independently from the adjacent pixels PXL.

After the separation process of the 1-1-th connection line CNL1_1, an insulating material layer (not show) is applied onto the first insulating material layer INSM1 and the light emitting elements LD, and a second insulating material layer INSM2 is formed by patterning the insulating material layer by a mask process. The second insulating material layer INSM2 may be formed of an inorganic insulating layer including an inorganic material, or an organic insulating layer including an organic material.

The second insulating material layer INSM2 may cover the first insulating material layer INSM1 disposed on each of the first and second sub-electrodes EL2_1 and EL2_2 of each of the second electrodes EL2. Furthermore, the second insulating material layer INSM2 may expose the first insulating material layer INSM1 disposed on each of the first electrodes EL1 and the first insulating material layer INSM1 disposed on the 1-1-th connection line CNL1_1. In addition, the second insulating material layer INSM2 may expose any of the opposite ends EP1 and EP2 of each of the light emitting elements LD to the outside.

Referring to FIGS. 1a to 1f, 2, 3a, 4, 6, and 12a to 12i, after a mask (not shown) is disposed over the second insulating material layer INSM2, a first insulating material pattern INSM1' is formed, using the mask, by patterning a portion of the first insulating material layer INSM1 that is exposed to the outside.

The first insulating material pattern INSM1' may expose at least one area of the first capping layer CPL1 disposed on each of the first electrodes EL1 to the outside and cover a remaining area other than the at least one area. Furthermore, the first insulating material pattern INSM1' may expose at least one area of the third capping layer CPL3 disposed on the first capping layer CPL1.

Referring to FIGS. 1a to 1f, 2, 3a, 4, 6, 11h, and 12a to 12j, the first contact electrode CNE1 is formed on the exposed portions of the first and third capping layers CPL1 and CPL3 and one of the opposite ends EP1 and EP2 of each light emitting element LD by a sputtering method or the like.

The first contact electrode CNE1 may be disposed on the exposed portion of the first capping layer CPL1 and electrically connected with each of the first electrodes EL1 disposed under the first capping layer CPL1. The first contact electrode CNE1 may be disposed on the exposed portion of the third capping layer CPL3 and electrically connected with each of the 1-2-th connection line CNL1_2 disposed under the third capping layer CPL3. Furthermore, the first contact electrode CNE1 may be electrically connected with one of the exposed opposite ends EP1 and EP2 of each of the light emitting elements LD.

Referring to FIGS. 1a to 1f, 2, 3a, 4, 6, and 12a to 12k, after a mask (not shown) is disposed over the passivation layer PSV on which the first contact electrode CNE1 is formed, the second insulating layer INS2 is formed by patterning the second insulating material layer INSM2 using the mask.

The second insulating layer INS2 may cover at least a portion of the upper surface of each of the light emitting elements LD such that the other of the opposite ends EP1 and EP2 of each of the light emitting elements LD may be exposed to the outside.

Thereafter, after an insulating material layer (not illustrated) is formed on the second insulating layer INS2, a mask (not illustrated) is disposed over the insulating material layer, and then the third insulating layer INS3 is formed by patterning the insulating material layer by a process using the mask. The third insulating layer INS3 may cover the first contact electrode CNE1 to protect the first contact electrode CNE1 from the outside, and may expose the first insulating material pattern INSM1' on the second electrodes EL2 and the other end of the opposite ends EP1 and EP2 of each of the light emitting elements LD to the outside.

Referring to FIGS. 1a to 1f, 2, 3a, 4, 6, and 12a to 12l, after a mask (not shown) is disposed over the passivation layer PSV including the third insulating layer INS3, the first insulating layer INS1 is formed by patterning the exposed portion of the first insulating material pattern INSM1'.

The first insulating layer INS1 may expose at least one area of the second capping layer CPL2 disposed on each of the second electrodes EL2 to the outside and cover a remaining area other than the one area.

Referring to FIGS. 1a to 1f, 2, 3a, 4, 6, 11i, and 12a to 12m, the second contact electrode CNE2 is formed on the other end of the exposed opposite ends EP1 and EP2 of each of the light emitting elements LD and the second capping layer CPL2.

The second contact electrode CNE2 may include a 2-1-th contact electrode CNE2_1 and a 2-2-th contact electrode CNE2_2. In a plan view, the 2-1-th contact electrode CNE2_1 and the 2-2-th contact electrode CNE2_2 may be spaced apart from each other by a predetermined distance with the first contact electrode CNE1 interposed therebetween.

The second contact electrode CNE2 may be electrically connected, through the second capping layer CPL2, with the first and second sub-electrodes EL2_1 and EL2_2 of each of the second electrodes EL2 disposed under the second capping layer CPL2.

Referring to FIGS. 1a to 1f, 2, 3a, 4, 6, and 12a to 12n, the fourth insulating layer INS4 is formed on an overall surface of the passivation layer PSV including the second contact electrode CNE2.

The fourth insulating layer INS4 may include an inorganic insulating layer made of an inorganic material, or an organic insulating layer made of an organic material. Although the fourth insulating layer INS4 may have a single layer structure as shown in the drawings, the present disclosure is not limited thereto. For example, the fourth insulating layer INS4 may have a multi-layer structure.

Subsequently, the overcoat layer OC is formed on the fourth insulating layer INS4.

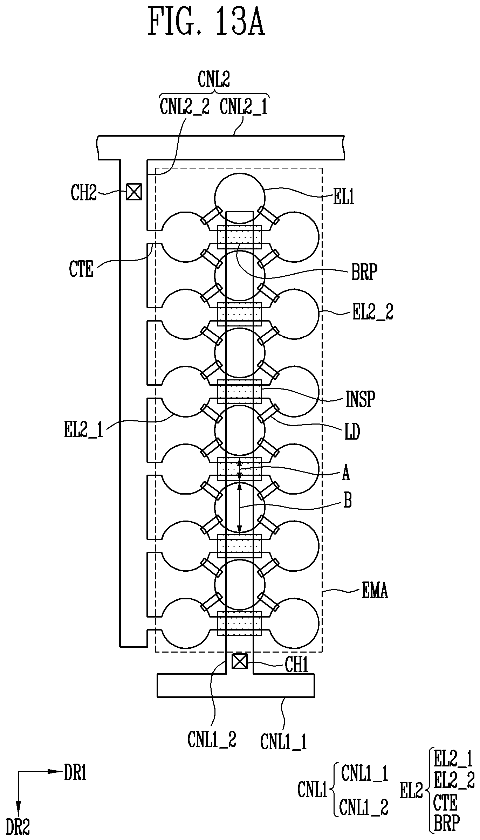

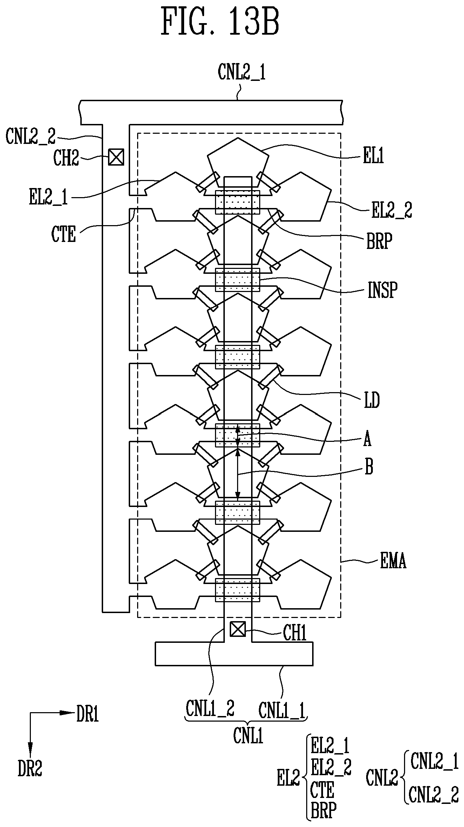

FIGS. 13a and 13b illustrate an embodiment of the first pixel of FIG. 5, and are plan views schematically illustrating the first pixel including only some components of a display element layer.

Although FIGS. 13a and 13b illustrate a simplified structure of the first pixel PXL1, e.g., showing only the first and second electrodes, the first and second connection lines, the light emitting elements, and the insulating pattern that are included in the display element layer of the first pixel PXL1, the present disclosure is not limited thereto

In addition, in FIGS. 13a and 13b, for the sake of explanation, illustration of the pixel circuit layer (including at least one transistor and signal lines electrically connected to the transistor) electrically connected to the light emitting elements is omitted.

The following description of embodiments of FIGS. 13a and 13b will be focused on differences from that of the foregoing embodiments, to avoid repetitive descriptions. Components which are not separately described in the following description of the embodiments of FIGS. 13a and 13b may comply with those of the foregoing embodiments. The same reference numeral will be used to designate the same component, and a similar reference numeral will be used to designate a similar component.

Referring to FIGS. 1a to 1f, 2, 13a, and 13b, the first pixel PXL1 includes first electrodes EL1, second electrodes EL2, light emitting elements LD, and first and second connection linesCNL1 and CNL2. Although not directly illustrated in FIGS. 13a and 13b, the first pixel PXL1 may further include a first partition wall (refer to PW1 of FIG. 4) disposed under each of the first electrodes EL1, a second partition wall (refer to PW2 of FIG. 4) disposed under each of the second electrodes EL2, a first capping layer (refer to CPL1 of FIG. 4) disposed on the first electrodes EL1, a second capping layer (refer to CPL2 of FIG. 4) disposed on the second electrodes EL2, a third capping layer (refer to CPL3 of FIG. 4) disposed on the first connection line CNL1, a first contact electrode (refer to CNE1 of FIG. 4) disposed on the first capping layer CPL1, and a second contact electrode (refer to CNE2 of FIG. 4) disposed on the second capping layer CPL2.

The first electrodes EL1 is provided in the emission area EMA of the first pixel PXL and be disposed at a position spaced apart from an adjacent first electrode EL1 in the second direction DR2 (e.g., "column direction"). In a plan view, each of the first electrodes EL1 may have a circular shape, but the shape of each of the first electrodes EL1 is not limited to that of the foregoing embodiment. In an embodiment, the first electrodes EL1 may have a polygonal shape including a pentagonal shape, as shown in FIG. 13b. Furthermore, in an embodiment, each of the first electrodes EL1 may have an elliptical shape, a hexagonal shape, etc.

The 1-2-th connection line CNL1_2 of the first connection line CNL1 may be provided and/or formed on the first electrodes EL1 disposed in the second direction DR2. The 1-2-th connection line CNL1_2 extends in the second direction DR2 and thus electrically connect the first electrodes EL1 spaced apart from each other in the second direction DR2.

Each of the second electrodes EL2 is provided in the emission area EMA of the first pixel PXL1 and be disposed at a position spaced apart from an adjacent second electrode EL2 in the second direction DR2. Each of the second electrodes EL2 includes an intermediate electrode CTE electrically connected to the second connection line CNL2, a first sub-electrode EL2_1 electrically connected to the intermediate electrode CTE, a bridge pattern BRP electrically connected to the first sub-electrode EL2_1, and a second sub-electrode EL2_2 electrically connected to the bridge pattern BRP.

Each of the first and second sub-electrodes EL2_1 and EL2_2 may be provided in various shapes. For example, the first and second sub-electrodes EL2_1 and EL2_2 may have a circular shape, as illustrated in FIG. 13a, or may have a pentagonal shape, as illustrated in FIG. 13b. Furthermore, the first and second sub-electrodes EL2_1 and EL2_2 each may have a shape identical to that of the first electrodes EL1, but the present disclosure is not limited thereto, and it may have a shape different from that of the first electrodes EL1.

In an embodiment of the present disclosure, the insulating pattern INSP may be provided on the bridge pattern BRP of each of the second electrodes EL2.

In an embodiment of the present disclosure, since the 1-2-th connection line CNL1_2 is disposed on the bridge pattern BRP of each of the second electrodes EL2 with the insulating pattern INSP interposed therebetween, the 1-2-th connection line CNL1_2 and the bridge pattern BRP of each of the second electrodes EL2 may be electrically insulated from each other.

In an embodiment of the present disclosure, first electrodes EL1 and second electrodes EL2 are alternately disposed in the second direction DR2 rather than being disposed in an identical row. In this case, one of the first electrodes EL1 may be disposed between two second electrodes EL2 adjacent thereto in the second direction DR2, so that the one of the first electrodes EL1 may be enclosed in the diagonal directions by the first and second sub-electrodes EL2_1 and EL2_2 of each of the two second electrodes EL2. Here, if the first electrodes EL1 and the second electrodes EL2 are respectively supplied with corresponding alignment voltages, electric fields may be formed in various directions between the first electrodes EL1 and the second electrodes EL2, so that the light emitting elements LD may be aligned in various directions in the emission area EMA of the first pixel PXL1. Therefore, light emitted from each of the light emitting elements LD may travel in various directions rather than being concentrated in a specific direction.

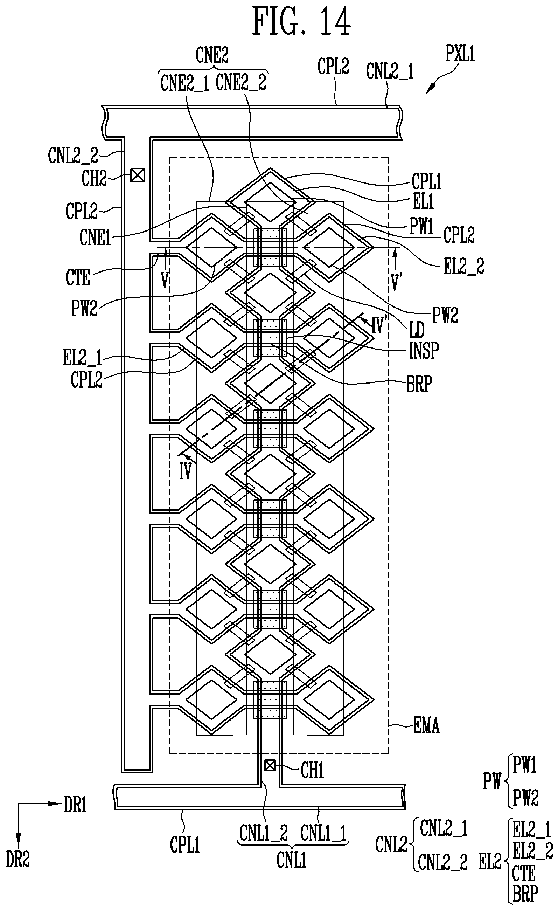

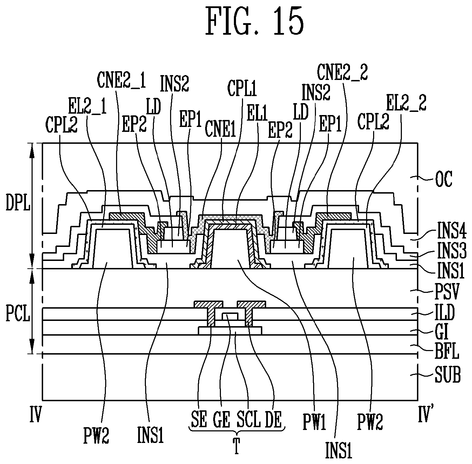

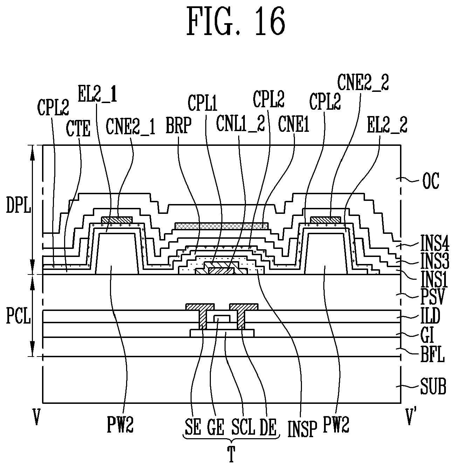

FIG. 14 illustrates a display device according to the invention, and is a schematic plan view corresponding to the first pixel of the first to third pixels of FIG. 4. FIG. 15 is a schematic cross-sectional diagram taken along line IV-IV' of FIG. 14. FIG. 16 is a schematic cross-sectional diagram taken along line V-V' of FIG. 14.

The first pixel illustrated in FIG. 14 may have a configuration different from that of the first pixel of FIG. 4 at least in that the first connection line is provided integrally with (or integral with) the first electrodes, and he first electrodes and the second electrodes are formed through different processes.

Therefore the description of the first pixel of FIGS. 14 to 16 will be focused on differences from that of the foregoing embodiments to avoid repetitive descriptions. Components which are not separately described in the following description of the present embodiment comply with those of the foregoing embodiments. The same reference numeral will be used to designate the same component, and a similar reference numeral will be used to designate a similar component.

Although FIGS. 14 to 16 simply illustrate the structure of the first pixel, e.g., in which each electrode is formed of a single electrode layer and each insulating layer is formed of a single insulating layer, the present disclosure is not limited thereto.

Referring to FIGS. 1a to 1f, 2, 3a, 14 to 16, the first pixel PXL1 may include a substrate SUB, a pixel circuit layer PCL disposed on the substrate SUB, and a display element layer DPL disposed on the pixel circuit layer PCL.

The pixel circuit layer PCL may include at least one transistor T, a driving voltage line DVL (see FIG. 6), and a passivation layer PSV. Here, the transistor T may include a first transistor T1 (T) which is a driving transistor, and a second transistor T2 (T) which is a switching transistor.

The display element layer DPL may include first and second partition walls PW1 and PW2, first electrodes EL1, second electrodes EL2, first and second connection lines CNL1 and CNL2, light emitting elements LD, first and second contact electrodes CNE1 and CNE2, an insulating pattern INSP, and first and second capping layers CPL1 and CPL2.

The first connection line CNL1 may include a 1-1-th connection line CNL1_1 extending in the first direction DR1, and a 1-2-th connection line CNL1_2 extending in the second direction DR2. The 1-2-th connection line CNL1_2 may be electrically connected to the second terminal DE of the first transistor T1 (T) of the pixel circuit layer PCL through the first contact hole CH1 passing through the passivation layer PSV.

In an embodiment of the present disclosure, the 1-2-th connection line CNL1_2 may be integral with the first electrodes EL1. In case that the 1-2-th connection line CNL1_2 is integral with the first electrodes EL1, the 1-2-th connection line CNL1_2 may be a predetermined area of the first electrodes EL1, or the first electrodes EL1 may be a predetermined area of the 1-2-th connection line CNL1_2. In case that the 1-2-th connection line CNL1_2 and the first electrodes EL1 are integral, the 1-2-th connection line CNL1_2 and the first electrodes EL1 may form an electrode column extending in the second direction DR2 in the emission area EMA of the first pixel PXL1.

The first connection line CNL1 and the first electrodes EL1 may include an identical material and be formed by an identical process. In other words, the first connection line CNL1 and the first electrodes EL1 may be provided on an identical layer.

The first capping layer CPL1 may be disposed on each of the first connection line CNL1 and the first electrodes EL1. The first capping layer CPL1 may be formed of a transparent conductive material and cover the first connection line CNL1 and the first electrodes EL1. The first capping layer CPL1 may reinforce adhesive force between the first connection line CNL1 and the passivation layer PSV and also reinforce adhesive force between the first electrodes EL1 and the passivation layer PSV.

The insulating pattern INSP may be provided on the first capping layer CPL1 on the 1-2-th connection line CNL1_2 and overlap the first capping layer CPL1 and the 1-2-th connection line CNL1_2. In an embodiment of the present disclosure, the insulating pattern INSP may overlap an area of the 1-2-th connection line CNL1_2 without overlapping the first electrodes EL1.

The second connection line CNL2 may include a 2-1-th connection line CNL2_1 extending in the first direction DR1, and a 2-2-th connection line CNL2_2 extending in the second direction DR2. The 2-2-th connection line CNL2_2 may be integral with the second electrodes EL2. In case that the 2-2-th connection line CNL2_2 is integral with the second electrodes EL2, the 2-2-th connection line CNL2_2 may be a predetermined area of the second electrodes EL2, or the second electrodes EL2 may be a predetermined area of the 2-2-th connection line CNL2_2.

The second electrodes EL2 and the second connection line CNL2 may be disposed on the pixel circuit layer PCL including the insulating pattern INSP. In an embodiment of the present disclosure, the second electrodes EL2 and the second connection line CNL2 may be formed through a process different from that of the first electrodes EL1 and the first connection line CNL1. Hence, the second electrodes EL2 and the second connection line CNL2 may be provided and/or formed on a layer different from that of the first electrodes EL1 and the first connection line CNL1.

Each of the second electrodes EL2 includes an intermediate electrode CTE electrically connected to the 2-2-th connection line CNL2_2, a first sub-electrode EL2_1 electrically connected to the intermediate electrode CTE, a bridge pattern BRP electrically connected to the first sub-electrode EL2_1, and a second sub-electrode EL2_2 electrically connected to the bridge pattern BRP. In an embodiment of the present disclosure, the bridge pattern BRP of each of the second electrodes EL2 may be disposed on the insulating pattern INSP.

Since the bridge pattern BRP of each of the second electrodes EL2 is disposed on the 1-2-th connection line CNL1_2 with the insulating pattern INSP interposed therebetween, the bridge pattern BRP of each of the second electrodes EL2 and the 1-2-th connection line CNL1_2 may be electrically insulated from each other.

The second capping layer CPL2 may be disposed on the second electrodes EL2 and the second connection line CNL2. The second capping layer CPL2 may be formed of transparent conductive material and cover the second connection line CNL2 and the second electrodes EL2. The second capping layer CPL2 may reinforce adhesive force between the second connection line CNL2 and the passivation layer PSV and also reinforce adhesive force between the second electrodes EL2 and the passivation layer PSV. In an embodiment of the present disclosure, the second capping layer CPL2 may be formed by a process different from that of the first capping layer CPL1. Hence, the second capping layer CPL2 and the first capping layer CPL1 may be provided and/or formed on respective different layers.

The second contact electrode CNE2 may be provided on the second electrodes EL2. The second contact electrode CNE2 may include a 2-1-th contact electrode CNE2_1 and a 2-2-th contact electrode CNE2_2. In a plan view, the 2-1-th contact electrode CNE2_1 may overlap the first sub-electrode EL2_1 of each of the second electrodes EL2 and any of the opposite ends EP1 and EP2 of each of the light emitting elements LD. In a plan view, the 2-2-th contact electrode CNE2_2 may overlap the second sub-electrode EL2_2 of each of the second electrodes EL2 and any of the opposite ends EP1 and EP2 of each of the light emitting elements LD.

The third insulating layer INS3 may be provided and/or formed on the second contact electrode CNE2.

The first contact electrode CNE1 may be disposed in an electrode column formed by the first electrodes EL1 and the 1-2-th connection line CNL1_2 integral with each other. In a plan view, the first contact electrode CNE1 may overlap each of the first electrodes EL1 and the other end of the opposite ends EP1 and EP2 of each of the light emitting elements LD.

The first contact electrode CNE1 and the second contact electrode CNE2 may be formed by different processes. For example, the first contact electrode CNE1 may be formed on the first electrode EL1 and the 1-2-th connection line CNL1_2 after the process of forming the third insulating layer INS3 on the second contact electrode CNE2. Therefore, the first contact electrode CNE1 and the second contact electrode CNE2 may be provided and/or formed on different layers.

Although in the foregoing embodiment the first contact electrode CNE1 is illustrated as being formed after the process of forming the second contact electrode CNE2, the present disclosure is not limited thereto. In an embodiment, the second contact electrode CNE2 may be formed after the first contact electrode CNE1 is formed. Furthermore, in an embodiment, the first contact electrode CNE1 and the second contact electrode CNE2 may be formed by an identical process.

In an embodiment of the present disclosure, the first electrodes EL1 and the second electrodes EL2 may be alternately disposed in the second direction DR2 rather than being disposed in an identical row. In this case, one of the first electrodes EL1 may be disposed between two second electrodes EL2 adjacent thereto in the second direction DR2, so that the one of the first electrodes EL1 may be enclosed in the diagonal directions by the first and second sub-electrodes EL2_1 and EL2_2 of each of the two second electrodes EL2. Particularly, in case that each of the first electrodes EL1 and the first and second sub-electrodes EL2_1 and EL2_2 of each of the second electrodes EL2 have a rhombic shape, the light emitting elements LD may be aligned in the emission area EMA of the first pixel PXL1 in various directions rather than being biased in a specific direction, e.g., the first direction DR1.

Therefore, light emitted from each of the light emitting elements LD may be prevented from being concentrated in a specific direction. Hence, the display device in an embodiment of the present disclosure may have uniform light output distribution on the overall area thereof.

While various embodiments have been described above, those skilled in the art will appreciate that various modifications, additions and substitutions are possible, without departing from the scope of the present disclosure.

Therefore, the embodiments disclosed in this specification are only for illustrative purposes rather than limiting the technical scope of the present disclosure. The scope of the claimed invention must be defined by the accompanying claims.

## Claims

1. A display device comprising:
a substrate (SUB) including a display area (DA) and a non-display area (NDA); and
at least one pixel (PXL) disposed in the display area (DA), and including an emission area (EMA) formed to emit light, wherein
the pixel (PXL) comprises:
first electrodes (EL1) disposed on the substrate (SUB) and disposed in a column direction;
second electrodes (EL2) spaced apart from the first electrodes (EL1);
a first connection line (CNL1) extending in the column direction, and connecting each of the first electrodes (EL1) to an adjacent first electrode (EL1);
a plurality of light emitting elements (LD) wherein each light emitting element (LD) is electrically connected to at least one of the first electrodes (EL1) and at least one of the second electrodes (EL2); and
an insulating pattern (INSP) overlapping the first connection line (CNL1), and
the first electrodes (EL1) and the second electrodes (EL2) are alternately disposed in the column direction in the emission area (EMA) in a plan view; and
wherein each of the second electrodes (EL2) comprises:
a bridge pattern (BRP) extending in a row direction intersecting the column direction, and overlapping the insulating pattern (INSP); and
at least two or more sub-electrodes (EL2_1, EL2_2) connected to each other by the bridge pattern (BRP).

2. The display device according to claim 1, wherein the bridge pattern (BRP) and the sub-electrodes (EL2_1, EL2_2) are integral with each other and form the at least one of the second electrodes (EL2).

3. The display device according to claim 2, wherein the at least one of the first electrodes (EL1) is disposed between two of the second electrodes (EL2) adjacent thereto in the column direction.

4. The display device according to of claim 2 or claim 3, wherein the insulating pattern (INSP) is disposed on the bridge pattern (BRP).

5. The display device according to claim 4, wherein the first connection line (CNL1) is disposed on a layer different from that of the first electrodes (EL1).

6. The display device according to claim 5, wherein the first connection line (CNL1) is disposed on the insulating pattern (INSP) and electrically disconnected from the bridge pattern (BRP), optionally
wherein:
the first connection line (CNL1) comprises:
a first part (A) overlapping the insulating pattern (INSP); and
a second part (B) other than the first part (A), and
the second part (B) of the first connection line (CNL1) is electrically connected with the first electrodes (EL1).

7. The display device according to claim 5 or claim 6, wherein the pixel (PXL) further comprises:
a first capping layer (CPL1) disposed on the first electrodes (EL1);
a second capping layer (CPL2) disposed on the second electrodes (EL2); and
a third capping layer (CPL3) disposed on the first connection line (CNL1), optionally
wherein:
the first and the second capping layers (CPL1, CPL2) are disposed on an identical layer, and the third capping layer (CPL3) is disposed on a layer different from that of the first and the second capping layers (CPL1, CPL2).

8. The display device according to any one of claims 1 to 7, wherein
the pixel (PXL) further comprises a second connection line (CNL2) electrically connected with the second electrodes (EL2), and
the second connection line (CNL2) comprises:
a 2-1-th connection line (CNL2_1) extending in the row direction; and
a 2-2-th connection line (CNL2_2) extending in the column direction, and
the 2-2-th connection line (CNL2_2) is integral with the second electrodes (EL2).

9. The display device according to claim 8, wherein the second connection line (CNL2) is disposed on a layer different from the that of first connection line (CNL1).

10. The display device according to claim 8 or claim 9, wherein the pixel (PXL) further comprises:
a partition wall (PW) disposed under each of the first electrodes (EL1) and the second electrodes (EL2);
a first contact electrode (CNE1) electrically connecting the at least one of the first electrodes (EL1) with an end of opposite ends of the light emitting element (LD); and
a second contact electrode (CNE2) electrically connecting the at least one of the second electrodes (EL2) with another end of the opposite ends of the light emitting element (LD), optionally
wherein:
the pixel (PXL) further comprises an insulating layer (INS2) disposed on an upper surface of the light emitting element (LD), and
the first contact electrode (CNE1) and the second contact electrode (CNE2) are spaced apart from each other on the insulating layer (INS2) and are electrically disconnected from each other.

11. The display device according to claim 2, wherein the first electrodes (EL1) and the first connection line (CNL1) are integral with each other.

12. The display device according to claim 11, wherein the insulating pattern (INSP) is disposed on the first connection line (CNL1), and the bridge pattern (BRP) is disposed on the insulating pattern (INSP), optionally
wherein:
the first electrodes (EL1) and the second electrodes (EL2) are disposed on different layers each other.

13. The display device according to claim 11 or claim 12,
wherein
the pixel (PXL) comprises:
a first capping layer (CPL1) disposed on each of the first electrodes (EL1) and the first connection line (CNL1); and
a second capping layer (CPL2) disposed on the second electrodes (EL2), and
the first capping layer (CPL1) and the second capping layer (CPL2) are disposed on different layers each other.

14. A method of fabricating a display device, comprising:
providing a substrate (SUB) including at least one pixel (PXL) having an emission area (EMA) and a non-emission area; and
forming, in the emission area (EMA) of the substrate (SUB), a display element layer (DPL) emitting light,
wherein the forming of the display element layer (DPL) comprises:
forming, in the emission area (EMA), first electrodes (EL1), second electrodes (EL2), and a first connection line (CNL1) electrically connected to the second electrodes (EL2);
forming an insulating pattern (INSP) overlapping portions of the second electrodes (EL2);
forming, on the insulating pattern (INSP), a second connection line (CNL2) electrically connected with the first electrodes (EL1);
aligning light emitting elements (LD) between at least one of the first electrodes (EL1) and at least one of the second electrodes (EL2); and
forming a first contact electrode (CNE1) electrically connecting the first electrodes (EL1) and an end of opposite ends of the light emitting element (LD), and a second contact electrode (CNE2) electrically connecting the second electrodes (EL2) and another end of the opposite ends of the light emitting element (LD), wherein:
each of the second electrodes (EL2) comprises:
a bridge pattern (BRP) extending in a row direction and overlapping the insulating pattern (INSP); and
two or more sub-electrodes (EL2_1, EL2_2) connected to each other by the bridge pattern (BRP).

## Patentansprüche

1. Anzeigevorrichtung, umfassend:
ein Substrat (SUB), das einen Anzeigebereich (DA) und einen Nichtanzeigebereich (NDA) einschließt; und
mindestens ein Pixel (PXL), das im Anzeigebereich (DA) angeordnet ist und einen Emissionsbereich (EMA) einschließt, der ausgebildet ist, um Licht zu emittieren, wobei das Pixel (PXL) umfasst:
erste Elektroden (EL1), die auf dem Substrat (SUB) angeordnet und in einer Spaltenrichtung angeordnet sind;
zweite Elektroden (EL2), die von den ersten Elektroden (EL1) beabstandet sind;
eine erste Verbindungsleitung (CNL1), die sich in der Spaltenrichtung erstreckt und jede der ersten Elektroden (EL1) mit einer angrenzenden ersten Elektrode (EL1) verbindet;
eine Vielzahl von lichtemittierenden Elementen (LD), wobei jedes lichtemittierende Element (LD) mit mindestens einer der ersten Elektroden (EL1) und mindestens einer der zweiten Elektroden (EL2) elektrisch verbunden ist; und
eine Isolierstruktur (INSP), welche die erste Verbindungsleitung (CNL1) überlappt, und
wobei die ersten Elektroden (EL1) und die zweiten Elektroden (EL2) in einer Draufsicht in Spaltenrichtung abwechselnd im Emissionsbereich (EMA) angeordnet sind; und
wobei jede der zweiten Elektroden (EL2) umfasst:
eine Brückenstruktur (BRP), die sich in einer Zeilenrichtung erstreckt, welche die Spaltenrichtung schneidet, und die Isolierstruktur (INSP) überlappt; und
mindestens zwei oder mehr Teilelektroden (EL2_1, EL2_2), die durch die Brückenstruktur (BRP) miteinander verbunden sind.

2. Anzeigevorrichtung nach Anspruch 1, wobei die Brückenstruktur (BRP) und die Teilelektroden (EL2_1, EL2_2) einstückig miteinander ausgebildet sind und die mindestens eine der zweiten Elektroden (EL2) ausbilden.

3. Anzeigevorrichtung nach Anspruch 2, wobei die mindestens eine der ersten Elektroden (EL1) zwischen zwei zweiten Elektroden (EL2), die in Spaltenrichtung daran angrenzen, angeordnet ist.

4. Anzeigevorrichtung nach Anspruch 2 oder 3, wobei die Isolierstruktur (INSP) auf der Brückenstruktur (BRP) angeordnet ist.

5. Anzeigevorrichtung nach Anspruch 4, wobei die erste Verbindungsleitung (CNL1) auf einer Schicht angeordnet ist, die sich von jener der ersten Elektroden (EL1) unterscheidet.

6. Anzeigevorrichtung nach Anspruch 5, wobei die erste Verbindungsleitung (CNL1) auf der Isolierstruktur (INSP) angeordnet und von der Brückenstruktur (BRP) elektrisch getrennt ist,
wobei optional:
die erste Verbindungsleitung (CNL1) umfasst:
einen ersten Teil (A), der die Isolierstruktur (INSP) überlappt; und
einen zweiten Teil (B), der sich vom ersten Teil (A) unterscheidet, und
wobei der zweite Teil (B) der ersten Verbindungsleitung (CNL1) mit den ersten Elektroden (EL1) elektrisch verbunden ist.

7. Anzeigevorrichtung nach Anspruch 5 oder Anspruch 6, wobei das Pixel (PXL) ferner umfasst:
eine erste Abdeckschicht (CPL1), die auf den ersten Elektroden (EL1) angeordnet ist;
eine zweite Abdeckschicht (CPL2), die auf den zweiten Elektroden (EL2) angeordnet ist; und
eine dritte Abdeckschicht (CPL3), die auf der ersten Verbindungsleitung (CNL1) angeordnet ist, wobei optional:
die erste und die zweite Abdeckschicht (CPL1, CPL2) auf einer identischen Schicht angeordnet sind und die dritte Abdeckschicht (CPL3) auf einer Schicht angeordnet ist, die sich von jener der ersten und der zweiten Abdeckschicht (CPL1, CPL2) unterscheidet.

8. Anzeigevorrichtung nach einem der Ansprüche 1 bis 7, wobei:
das Pixel (PXL) ferner eine zweite Verbindungsleitung (CNL2) umfasst, die mit den zweiten Elektroden (EL2) elektrisch verbunden ist, und
die zweite Verbindungsleitung (CNL2) umfasst:
eine 2-1-te Verbindungsleitung (CNL2_1), die sich in Zeilenrichtung erstreckt; und
eine 2-2-te Verbindungsleitung (CNL2_2), die sich in Spaltenrichtung erstreckt, und
wobei die 2-2-te Verbindungsleitung (CNL2_2) einstückig mit den zweiten Elektroden (EL2) ausgebildet ist.

9. Anzeigevorrichtung nach Anspruch 8, wobei die zweite Verbindungsleitung (CNL2) auf einer Schicht angeordnet ist, die sich von jener der ersten Verbindungsleitung (CNL1) unterscheidet.

10. Anzeigevorrichtung nach Anspruch 8 oder Anspruch 9, wobei die Pixel (PXL) ferner umfassen:
eine Trennwand (PW), die unter jeder der ersten Elektroden (EL1) und der zweiten Elektroden (EL2) angeordnet ist;
eine erste Kontaktelektrode (CNE1), welche die mindestens eine der ersten Elektroden (EL1) mit einem Ende von gegenüberliegenden Enden des lichtemittierenden Elements (LD) elektrisch verbindet; und
eine zweite Kontaktelektrode (CNE2), welche die mindestens eine der zweiten Elektroden (EL2) mit einem anderen Ende der gegenüberliegenden Enden des lichtemittierenden Elements (LD) elektrisch verbindet, wobei optional:
das Pixel (PXL) ferner eine Isolierschicht (INS2) umfasst, die auf einer Oberseite des lichtemittierenden Elements (LD) angeordnet ist, und
die erste Kontaktelektrode (CNE1) und die zweite Kontaktelektrode (CNE2) auf der Isolierschicht (INS2) voneinander beabstandet sind und voneinander elektrisch getrennt sind.

11. Anzeigevorrichtung nach Anspruch 2, wobei die ersten Elektroden (EL1) und die erste Verbindungsleitung (CNL1) einstückig miteinander sind.

12. Anzeigevorrichtung nach Anspruch 11, wobei die Isolierstruktur (INSP) auf der ersten Verbindungsleitung (CNL1) angeordnet ist und die Brückenstruktur (BRP) auf der Isolierstruktur (INSP) angeordnet ist, wobei optional:
die ersten Elektroden (EL1) und die zweiten Elektroden (EL2) auf voneinander verschiedenen Schichten angeordnet sind.

13. Anzeigevorrichtung nach Anspruch 11 oder Anspruch 12, wobei
das Pixel (PXL) umfasst:
eine erste Abdeckschicht (CPL1), die auf jeder der ersten Elektroden (EL1) und der ersten Verbindungsleitung (CNL1) angeordnet ist; und
eine zweite Abdeckschicht (CPL2), die auf den zweiten Elektroden (EL2) angeordnet ist, und
wobei die erste Abdeckschicht (CPL1) und die zweite Abdeckschicht (CPL2) auf voneinander verschiedenen Schichten angeordnet sind.

14. Verfahren zur Herstellung einer Anzeigevorrichtung, umfassend:
Bereitstellen eines Substrats (SUB), das mindestens ein Pixel (PXL) mit einem Emissionsbereich (EMA) und einem Nichtemissionsbereich einschließt; und
Ausbilden einer Anzeigeelementschicht (DPL), die Licht emittiert, im Emissionsbereich (EMA) des Substrats (SUB),
wobei das Ausbilden der Anzeigeelementschicht (DP1) umfasst:
Ausbilden von ersten Elektroden (EL1), zweiten Elektroden (EL2) und einer ersten Verbindungsleitung (CNL1), die mit den zweiten Elektroden (EL2) elektrisch verbunden ist, im Emissionsbereich (EMA);
Ausbilden einer Isolierstruktur (INSP), die Abschnitte der zweiten Elektroden (EL2) überlappt;
Ausbilden einer zweiten Verbindungsleitung (CNL2), die mit den ersten Elektroden (EL1) elektrisch verbunden ist, auf der Isolierstruktur (INSP);
Ausrichten von lichtemittierenden Elementen (LD) zwischen mindestens einer der ersten Elektroden (EL1) und mindestens einer der zweiten Elektroden (EL2); und
Ausbilden einer ersten Kontaktelektrode (CNE1), welche die ersten Elektroden (EL1) und ein Ende von gegenüberliegenden Enden des lichtemittierenden Elements (LD) elektrisch verbindet, und einer zweiten Kontaktelektrode (CNE2), welche die zweiten Elektroden (EL2) und ein anderes Ende der gegenüberliegenden Enden des lichtemittierenden Elements (LD) elektrisch verbindet, wobei:
jede der zweiten Elektroden (EL2) umfasst:
eine Brückenstruktur (BRP), die sich in einer Zeilenrichtung erstreckt und die Isolierstruktur (INSP) überlappt; und
zwei oder mehr Teilelektroden (EL2_1, EL2_2), die durch die Brückenstruktur (BRP) miteinander verbunden sind.

## Revendications

1. Dispositif d'affichage comprenant :
un substrat (SUB) incluant une zone d'affichage (DA) et une zone de non-affichage (NDA) ; et
au moins un pixel (PXL) disposé dans la zone d'affichage (DA), et incluant une zone d'émission (EMA) formée pour émettre de la lumière, dans lequel le pixel (PXL) comprend :
de premières électrodes (EL1) disposées sur le substrat (SUB) et disposées dans un sens de colonne ;
de deuxièmes électrodes (EL2) espacées des premières électrodes (EL1) ;
une première ligne de connexion (CNL1) s'étendant dans le sens de colonne et connectant chacune des premières électrodes (EL1) à une première électrode adjacente (EL1) ;
une pluralité d'éléments émetteurs de lumière (LD), dans lequel chaque élément émetteur de lumière (LD) est connecté électriquement à au moins une des premières électrodes (EL1) et à au moins une des deuxièmes électrodes (EL2) ; et
un motif isolant (INSP) chevauchant la première ligne de connexion (CNL1), et
les premières électrodes (EL1) et les deuxièmes électrodes (EL2) étant disposées alternativement dans le sens de colonne dans la zone d'émission (EMA) dans une vue en plan ; et
dans lequel chacune des deuxièmes électrodes (EL2) comprend :
un motif de pont (BRP) s'étendant dans un sens de rangée coupant le sens de colonne, et chevauchant le motif isolant (INSP) ; et
au moins deux sous-électrodes ou plus (EL2_1, EL2_2), connectées entre elles par le motif de pont (BRP).

2. Dispositif d'affichage selon la revendication 1, dans lequel le motif de pont (BRP) et les sous-électrodes (EL2_1, EL2_2) sont solidaires et forment l'au moins une des deuxièmes électrodes (EL2).

3. Dispositif d'affichage selon la revendication 2, dans lequel l'au moins une des premières électrodes (EL1) est disposée entre deux des deuxièmes électrodes (EL2) lui adjacentes dans le sens de colonne.

4. Dispositif d'affichage selon la revendication 2 ou la revendication 3, dans lequel le motif isolant (INSP) est disposé sur le motif de pont (BRP).

5. Dispositif d'affichage selon la revendication 4, dans lequel la première ligne de connexion (CNL1) est disposée sur une couche différente de celle des premières électrodes (EL1).

6. Dispositif d'affichage selon la revendication 5, dans lequel la première ligne de connexion (CNL1) est disposée sur le motif isolant (INSP) et déconnectée électriquement du motif de pont (BRP), facultativement
dans lequel :
la première ligne de connexion (CNL1) comprend :
une première partie (A) chevauchant le motif isolant (INSP) ; et
une deuxième partie (B) différente de la première partie (A), et
la deuxième partie (B) de la première ligne de connexion (CNL1) est connectée électriquement aux premières électrodes (EL1).

7. Dispositif d'affichage selon la revendication 5 ou la revendication 6, dans lequel le pixel (PXL) comprend en outre :
une première couche de recouvrement (CPL1) disposée sur les premières électrodes (EL1) ;
une deuxième couche de recouvrement (CPL2) disposée sur les deuxièmes électrodes (EL2) ; et
une troisième couche de recouvrement (CPL3) disposée sur la première ligne de connexion (CNL1), facultativement dans lequel :
les première et deuxième couches de recouvrement (CPL1, CPL2) sont disposées sur une couche identique, et la troisième couche de recouvrement (CPL3) est disposée sur une couche différente de celle des première et deuxième couches de recouvrement (CPL1, CPL2).

8. Dispositif d'affichage selon l'une quelconque des revendications 1 à 7, dans lequel
le pixel (PXL) comprend en outre une deuxième ligne de connexion (CNL2) connectée électriquement aux deuxièmes électrodes (EL2), et
la deuxième ligne de connexion (CNL2) comprend :
une 2-1e ligne de connexion (CNL2_1) s'étendant dans le sens de rangée ; et
une 2-2e ligne de connexion (CNL2_2) s'étendant dans le sens de colonne, et
la 2-2e ligne de connexion (CNL2_2) est solidaire des deuxièmes électrodes (EL2).

9. Dispositif d'affichage selon la revendication 8, dans lequel la deuxième ligne de connexion (CNL2) est disposée sur une couche différente de celle de la première ligne de connexion (CNL1).

10. Dispositif d'affichage selon la revendication 8 ou la revendication 9, dans lequel le pixel (PXL) comprend en outre :
une paroi de séparation (PW) disposée sous chacune des premières électrodes (EL1) et des deuxièmes électrodes (EL2) ;
une première électrode de contact (CNE1) connectant électriquement l'au moins une des premières électrodes (EL1) à une extrémité d'extrémités opposées de l'élément émetteur de lumière (LD) ; et
une deuxième électrode de contact (CNE2) connectant électriquement l'au moins une des deuxièmes électrodes (EL2) à une autre extrémité des extrémités opposées de l'élément émetteur de lumière (LD) ; facultativement dans lequel :
le pixel (PXL) comprend en outre une couche isolante (INS2) disposée sur une surface supérieure de l'élément émetteur de lumière (LD), et
la première électrode de contact (CNE1) et la deuxième électrode de contact (CNE2) sont espacées l'une de l'autre sur la couche isolante (INS2) et sont électriquement déconnectées l'une de l'autre.

11. Dispositif d'affichage selon la revendication 2, dans lequel les premières électrodes (EL1) et la première ligne de connexion (CNL1) sont solidaires.

12. Dispositif d'affichage selon la revendication 11, dans lequel le motif isolant (INSP) est disposé sur la première ligne de connexion (CNL1), et le motif de pont (BRP) est disposé sur le motif isolant (INSP), facultativement dans lequel :
les premières électrodes (EL1) et les deuxièmes électrodes (EL2) sont disposées sur des couches différentes l'une de l'autre.

13. Dispositif d'affichage selon la revendication 11 ou la revendication 12, dans lequel le pixel (PXL) comprend :
une première couche de recouvrement (CPL1) disposée sur chacune des premières électrodes (EL1) et la première ligne de connexion (CNL1) ; et
une deuxième couche de recouvrement (CPL2) disposée sur les deuxièmes électrodes (EL2), et
la première couche de recouvrement (CPL1) et la deuxième couche de recouvrement (CPL2) sont disposées sur des couches différentes l'une de l'autre.

14. Procédé de fabrication d'un dispositif d'affichage, comprenant :
la fourniture d'un substrat (SUB) incluant au moins un pixel (PXL) ayant une zone d'émission (EMA) et une zone de non-émission ; et
la formation, dans la zone d'émission (EMA) du substrat (SUB), d'une couche d'éléments d'affichage (DPL) émettant de la lumière,
dans lequel la formation de la couche d'éléments d'affichage (DPL) comprend :
la formation, dans la zone d'émission (EMA), de premières électrodes (EL1), des deuxièmes électrodes (EL2) et d'une première ligne de connexion (CNL1) connectée électriquement aux deuxièmes électrodes (EL2) ;
la formation d'un motif isolant (INSP) chevauchant des parties des deuxièmes électrodes (EL2) ;
la formation, sur le motif isolant (INSP), d'une deuxième ligne de connexion (CNL2) reliée électriquement aux premières électrodes (EL1) ;
l'alignement d'éléments émetteurs de lumière (LD) entre au moins une des premières électrodes (EL1) et au moins une des deuxièmes électrodes (EL2) ; et
la formation d'une première électrode de contact (CNE1) connectant électriquement les premières électrodes (EL1) et une extrémité d'extrémités opposées de l'élément émetteur de lumière (LD), et une deuxième électrode de contact (CNE2) connectant électriquement les deuxièmes électrodes (EL2) et une autre extrémité des extrémités opposées de l'élément émetteur de lumière (LD), dans lequel :
chacune des deuxièmes électrodes (EL2) comprend :
un motif de pont (BRP) s'étendant dans une direction de rangée et chevauchant le motif isolant (INSP) ; et
deux sous-électrodes ou plus (EL2_1, EL2_2) connectées entre elles par le motif de pont (BRP).
